(19) Europäisches Patentamt
European Patent Office
Office européen des brevets

(11) **EP 3 625 933 B1**

(12) **EUROPÄISCHE PATENTSCHRIFT**

(45) Veröffentlichungstag und Bekanntmachung des Hinweises auf die Patenterteilung:
**19.08.2020 Patentblatt 2020/34**

(21) Anmeldenummer: **18788728.6**

(22) Anmeldetag: **12.10.2018**

(51) Int Cl.:
*H04L 12/26* (2006.01)　　　*G01R 19/175* (2006.01)
*H02H 7/26* (2006.01)　　　*G01R 19/25* (2006.01)
*G01R 21/133* (2006.01)　　　*H02H 7/30* (2006.01)
*H02J 13/00* (2006.01)

(86) Internationale Anmeldenummer:
**PCT/EP2018/077921**

(87) Internationale Veröffentlichungsnummer:
**WO 2019/101433 (31.05.2019 Gazette 2019/22)**

(54) **BUSKLEMME FÜR EIN AUTOMATISIERUNGSSYSTEM UND VERFAHREN ZUM ÜBERWACHEN EINES VERSORGUNGSSTROMNETZES**

BUS TERMINAL FOR AN AUTOMATION SYSTEM AND METHOD FOR MONITORING A POWER SUPPLY NETWORK

BORNE DE BUS POUR SYSTÈME D'AUTOMATISATION ET PROCÉDÉ DESTINÉ À CONTRÔLER UN RÉSEAU ÉLECTRIQUE D'ALIMENTATION

(84) Benannte Vertragsstaaten:
**AL AT BE BG CH CY CZ DK EE ES FI FR GB GR HR HU IE IS IT LI LT LU LV MC MK MT NL NO PL PT RO RS SE SI SK SM TR**

(30) Priorität: **24.11.2017 DE 102017127766**

(43) Veröffentlichungstag der Anmeldung:
**25.03.2020 Patentblatt 2020/13**

(73) Patentinhaber: **Beckhoff Automation GmbH 33415 Verl (DE)**

(72) Erfinder:
• **ASSION, Fabian**
**33647 Bielefeld (DE)**
• **LIENEN, Christian**
**33129 Delbrück (DE)**
• **ENS, Jakob**
**33428 Harsewinkel (DE)**

(74) Vertreter: **Patentanwaltskanzlei WILHELM & BECK
Prinzenstraße 13
80639 München (DE)**

(56) Entgegenhaltungen:
**WO-A1-2015/180766　　　US-A1- 2017 131 343**

• **Sascha Rentzig: "Die Energiewende wird digital", , 1. Januar 2017 (2017-01-01), XP055532651, Gefunden im Internet: URL:https://www.wago.com/medias/WAGOdirect -Energy-1-2017.pdf?context=bWFzdGVyfHJvb3 R 8MjkzNjY4MHxhcHBsaWNhdGlvbi9wZGZ8aDhlL 2gzO C84ODc2NDQ0MzE5Nzc0LnBkZnxiNWZhMzY2N TFmZjM wZGEyNzMwYWRhMTdhNjM3N2VkYjBkOTdhYz lkOTc4Z TRhYzQ3ZjgxMzY4NDJmYzg5ZDEw [gefunden am 2018-12-11]**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft eine Busklemme für ein Automatisierungssystem bzw. eines Automatisierungssystems und ein Verfahren zum Überwachen eines Versorgungsstromnetzes.

Die Patentschrift EP 2 017 870 B1 beschreibt ein System und ein Verfahren, um mittels Messungen ein Schalten eines mikroelektromechanischen Schalters im Nulldurchgang zu ermöglichen, wobei folgende Komponenten vorgesehen sind: Lastschaltung, Detektionsschaltung, Wechselspannungsquelle, Lastwechselstrom, Spannungsmessschaltung, Strommessschaltung, mikroelektromechanischer Schalter.

Die Patentschrift DE 2 155 470 B beschreibt eine digitale Nulldurchgangsbestimmung eines sinusförmigen Wechselstromsignals mit einer festen Abtastperiode. Ein Nulldurchgang wird dadurch bestimmt, dass ein Produkt aus zwei aufeinander folgenden Messwerten gebildet wird und, wenn dieses negativ ist, wird zur Bestimmung des Nulldurchgangs eine lineare Interpolation zwischen den beiden Messwerten gebildet. Zur Bestimmung der Frequenz wird der zeitliche Abstand der Nulldurchgänge bestimmt.

Als verteilte Versorgungsstromnetze werden in der elektrischen Energietechnik Netzwerke aus elektrischen Stromleitungen wie Freileitungen und Erdkabeln und die dazugehörigen Einrichtungen wie Schalt-, Umspannwerke und die daran angeschlossenen Kraftwerke und Verbraucher bezeichnet. Große, räumlich benachbarte und elektrisch verbundene Versorgungsstromnetze werden beispielsweise als Verbundnetz bezeichnet, kleine, räumlich getrennte Versorgungsstromnetze beispielswiese als Inselnetze. In verteilten Versorgungsstromnetzen wird bisher nur sehr alte Technik eingesetzt, die eine sichere Abschaltung von Teilen des Versorgungsstromnetzes bei auftretenden Fehlern ermöglicht. Ein auftretender Fehler könnte beispielsweise ein Kurzschluss innerhalb eines Teiles und/oder innerhalb einer Komponente des Versorgungsstromnetzes sein. Nachteile dieser Technik sind die ungenaue Lokalisation der Fehler kurz nach dem Auftreten und der fehlende Zugang zur zeitlichen Ausbreitung des Fehlers. Dies ist dadurch begründet, dass nur eine sehr grobe Synchronisation der Uhrzeit der verschiedenen Messpunkte innerhalb des Versorgungsstromnetzes stattfindet. Dadurch zeigen die verschiedenen Messpunkte ein Auftreten eines Fehlers mit bis zu einigen Sekunden Versatz untereinander an, obwohl sich der Fehler mit einer Geschwindigkeit von maximal der Lichtgeschwindigkeit ausbreitet. Außerdem trennt nicht zwingendermaßen die Sicherung den fehlerhaften Teil des Versorgungsstromnetzes, die dem Fehler am nächsten ist. Dadurch werden teilweise unnötig große Teile des Versorgungsstromnetzes abgeschaltet und somit Verbraucher von der Versorgung abgeschnitten.

Die US 2017/131343 A1 offenbart eine Vorrichtung zum Überwachen eines Versorgungsstromnetzes, bei der eine erste Uhr, eine Kommunikationsschnittstelle, einen Analog-Digital-Umsetzer zum Messen elektrischer Größen des Versorgungsstromnetzes und eine Prozessoreinrichtung aufweisend eine Sucheinheit vorgesehen sind.

WO 2015/180766 A1 offenbart eine Vorrichtung zur Überwachung eines Versorgungsstromnetzes und eine zugehörige Leitstelleneinrichtung.

Sascha Rentzig:"Die Energiewende wird digital", 1. Januar 2017, XP055532651 (https://www.wago.com/medias/WAGOdirect-Energy-1-2017.pdf? context=bWFzdGVyfHJvb3R8MjkzNjY4MhxhcHBsaWNhdGlvbi9wZGZ8aDhlL2gz0C840Dc2NDQOMzE5NzcOLnBkZnxiNWZhMzY2NT FmZjMwZGEyNzMwYWRhMTdhNjM3N2VkYjBkOTdh YzlkOTc4ZTRhYzQ3ZjgxMzY4 4NDJmYzg5ZDEw [gefunden am 2018-12-11]) offenbart die Verwendung von Busklemmen zur Überwachung von Versorgungsstromnetzen, insbesondere zur Überwachung der Spannung in Versorgungsstromnetzen.

Die der Erfindung zugrundeliegende Aufgabe ist daher darin zu sehen, ein Konzept zum effizienten Überwachen eines Versorgungsstromnetzes bereitzustellen.

Diese Aufgabe wird mittels des jeweiligen Gegenstands der unabhängigen Ansprüche gelöst. Vorteilhafte Ausgestaltungen der Erfindung sind Gegenstand von jeweils abhängigen Unteransprüchen.

Nach einem ersten Aspekt wird eine Busklemme für ein Automatisierungssystem zum Überwachen eines Versorgungsstromnetzes bereitgestellt, wobei die Busklemme umfasst:

eine erste Uhr,
eine Kommunikationsschnittstelle zum Kommunizieren über ein Kommunikationsnetzwerk des Automatisierungssystems,
wobei die Kommunikationsschnittstelle ausgebildet ist, eine Referenzzeit über das Kommunikationsnetzwerk zu empfangen,
wobei die Kommunikationsschnittstelle ausgebildet ist, die Uhrzeit der ersten Uhr auf die Referenzzeit zu synchronisieren,
einen als Analog-Digital-Umsetzer ausgebildeten Messumsetzer zum Messen einer oder mehrerer elektrischer Größen des Versorgungsstromnetzes, um basierend auf der einen oder den mehreren gemessenen elektrischen Größen entsprechende digitale Messdaten bereitzustellen,
und eine Prozessoreinrichtung aufweisend:

eine zweite Uhr, die ausgebildet ist, basierend auf einem der zweiten Uhr vom Messumsetzer zugeführten Bereitstellungssignal ein Zeitsignal zu generieren, wobei die zweite Uhr weiterhin ausgebildet ist, die erste Uhr zu veranlassen, periodisch die synchronisierte Uhrzeit bereitzustellen,

eine erste Verknüpfungseinheit, die ausgebildet ist, den bereitgestellten digitalen Messdaten das Zeitsignal zuzuordnen, eine Sucheinheit, die ausgebildet ist, die bereitgestellten digitalen Messdaten und/oder auf den bereitgestellten digitalen Messdaten basierende erste abgeleitete Daten auf das Eintreten eines oder mehrerer vorbestimmter Ereignisse hin zu untersuchen, um basierend auf der Feststellung des Eintreten eines oder mehrerer vorbestimmter Ereignisse entsprechende, auf den digitalen Messdaten und/oder auf den ersten abgeleiteten Daten des Ereignisses oder der Ereignisse basierende Ereignisdaten zu generieren,

eine zweite Verknüpfungseinheit, die ausgebildet ist, die Ereignisdaten und/oder auf den Ereignisdatendaten basierende zweite abgeleitete Daten mit einem Zeitstempel zu versehen, um somit Nutzdaten zu generieren, wobei der Zeitstempel basiert auf einer Verknüpfung der von der ersten Uhr bereitgestellten synchronisierten Uhrzeit und dem den digitalen Messdaten des Ereignisses oder der Ereignisse zugeordneten Zeitsignal,

wobei die Kommunikationsschnittstelle ausgebildet ist, die generierten Nutzdaten über das Kommunikationsnetzwerk zu senden.

Nach einem zweiten Aspekt wird ein Verfahren zum Überwachen eines Versorgungsstromnetzes unter Verwendung der Busklemme für ein Automatisierungssystem bereitgestellt, umfassend die folgenden Schritte:

Empfangen einer Referenzzeit über das Kommunikationsnetzwerk, Synchronisieren der Uhrzeit der ersten Uhr auf die Referenzzeit,

Messen einer oder mehrerer elektrischer Größen des Versorgungsstromnetzes mittels des als Analog-Digital-Umsetzer ausgebildeten Messumsetzers,

Bereitstellen von auf der einen oder den mehreren gemessenen elektrischen Größen entsprechend basierenden digitalen Messdaten,

Zuführen eines Bereitstellungssignals seitens des Messumsetzers an die zweite Uhr, sobald digitale Messdaten bereitstehen,

Generieren eines Zeitsignals seitens der zweiten Uhr, wenn das Bereitstellungssignal zugeführt wird, periodischen Veranlassung der ersten Uhr die synchronisierte Uhrzeit bereitzustellen seitens der zweiten Uhr,

Zuordnung des Zeitsignals an die bereitgestellten digitalen Messdaten,

Untersuchung (bzw. Untersuchen) der bereitgestellten digitalen Messdaten und/oder der auf den bereitgestellten digitalen Messdaten basierenden ersten abgeleiteten Daten auf das Eintreten eines oder mehrerer vorbestimmter Ereignisse hin, basierend auf der Feststellung des Eintretens eines oder mehrerer vorbestimmter Ereignisse, Generierung von entsprechenden, auf den digitalen Messdaten und/oder auf den ersten abgeleiteten Daten des Ereignisses oder der Ereignisse basierenden Ereignisdaten,

Versehen der Ereignisdaten und/oder der auf den Ereignisdatendaten basierenden zweiten abgeleiteten Daten mit einem Zeitstempel, wobei der Zeitstempel basiert auf einer Verknüpfung der von der ersten Uhr bereitgestellten synchronisierten Uhrzeit und dem den digitalen Messdaten des Ereignisses oder der Ereignisse zugeordneten Zeitsignal,

Generieren von Nutzdaten aus den mit dem Zeitstempel versehenen Ereignisdaten und/oder den mit dem Zeitstempel versehenen, auf den Ereignisdatendaten basierenden zweiten abgeleiteten Daten,

Senden der generierten Nutzdaten über das Kommunikationsnetzwerk.

Die Erfindung basiert auf der Erkenntnis, dass die obige Aufgabe dadurch gelöst werden kann, dass mittels der Busklemme gezielt nach einem oder mehreren vorbestimmten Ereignissen innerhalb der Messdaten und/oder innerhalb der auf den Messdaten basierenden ersten abgeleiteten Daten gesucht werden kann, wobei die gesuchten Ereignisse entsprechende Ereignisse innerhalb des Versorgungsstromnetzes repräsentieren. Die gefundenen Ereignisse werden dann mit einem Zeitstempel verknüpft, wobei der Zeitstempel ferner zeitlich mit den digitalen Messdaten verknüpft ist, so dass der Zeitstempel insbesondere von einem Zeitpunkt der Messung der einen oder mehreren elektrischen Größen abhängt. Das Zuordnen des Zeitstempels wird mittels der Prozessoreinrichtung durchgeführt.

Der Zeitstempel stellt also relativ zur Referenzzeit eine Zeitinformation bereit, die beispielsweise angibt, wann relativ zur Referenzzeit die digitalen Messdaten gemessen bzw. bereitgestellt wurden bzw. wann das gesuchte Ereignis oder wann die gesuchten Ereignisse in dem Versorgungsstromnetz eingetreten ist oder sind.

Die mit einem solchen Zeitstempel versehenen Nutzdaten werden über das Kommunikationsnetzwerk gesendet und können somit anderen Kommunikationsteilnehmern des Automatisierungssystems, welches auch als Kommunikationsnetzwerk oder Feldbussystem bezeichnet werden kann, zur Verfügung gestellt. Ein anderer Kommunikationsteilnehmer des Automatisierungssystems kann als Steuerung des Automatisierungssystems ausgebildet sein. Auch kann es sich bei dem Kommunikationsteilnehmer um einen Master bzw. Feldbusmaster des Automatisierungssystems handeln. Ebenso kann der Kommunikationsteilnehmer ein oder eine Mehrzahl beliebiger anderer Teilnehmer, wie beispielsweise Feldbuskoppler und/oder Busklemmen, welche auch als Feldbusklemmen bezeichnet werden können, im Feldbussystem sein. Die erfindungsgemäße Busklemme kann somit selber ein Kommunikationsteilnehmer des Automatisierungssystems sein und dadurch wie ein gewöhnlicher Teilnehmer des Feldbussystems angesprochen werden. Die Nutzdaten können über den Feldbus mit den anderen Kommunikationsteilnehmern ausgetauscht werden. Eine externe Verkabelung zum Anschluss der erfindungsgemäßen Busklemme an das Feldbussystem entfällt damit.

Bei einer alternativen Ausführungsform der erfindungsgemäßen Busklemme kann die Busklemme auch als gesondertes Bauelement innerhalb eines Automatisierungssystems ausgebildet sein, welches dann mittels entsprechender Verkabelungen mit dem Automatisierungssystem verbindbar ist.

Somit können in vorteilhafter Weise die mit dem Zeitstempel versehenen Nutzdaten zeitlich für das Automatisierungssystem eingeordnet werden. Das heißt beispielsweise, dass verschiedene Nutzdaten von mehreren erfindungsgemäßen Busklemmen zeitlich miteinander verglichen werden können und zum Beispiel in eine zeitliche Reihenfolge gebracht werden können. Dies deshalb, da die internen Uhren der mehreren Busklemmen auf die gleiche Referenzzeit synchronisiert wurden.

Dadurch wird zum Beispiel der technische Vorteil bewirkt, dass ein Fehler innerhalb des Versorgungsstromnetzes effizient und zeitnah lokalisiert werden kann.

Dadurch kann weiter beispielsweise der technische Vorteil bewirkt werden, dass nur diejenige Sicherung den fehlerhaften Teil des Versorgungsstromnetzes vom Rest des Versorgungsstromnetzes trennt, die dem Fehlerort am nächsten ist. Dadurch wird insbesondere in vorteilhafter Weise bewirkt, dass nicht unnötig große Teile vom Versorgungsstromnetz abgeschaltet werden.

Bei der Formulierung "Busklemme für ein Automatisierungssystem" soll die Formulierung "Busklemme eines Automatisierungssystems" mitgelesen werden und umgekehrt.

In einer Ausführungsform ist das Automatisierungssystem vorgesehen, welches die Busklemme umfasst.

In einer Ausführungsform umfasst das Automatisierungssystem das Kommunikationsnetzwerk.

In einer Ausführungsform umfasst das Automatisierungssystem das Versorgungsstromnetz.

In einer Ausführungsform umfasst das Versorgungsstromnetz die Busklemme.

Bei der Formulierung "zum Überwachen eines Versorgungsstromnetzes" soll die Formulierung "zum Überwachen eines Versorgungsstromnetzes des Automatisierungssystems" mitgelesen werden.

Ein Nulldurchgang ist zum Beispiel ein Nulldurchgang einer Spannung und/oder eines Stroms und/oder einer aus der Spannung bzw. dem Strom abgeleiteten Größe.

Nach einer vorteilhaften Ausführungsform der Busklemme ist vorgesehen, dass die Prozessoreinrichtung eine erste Auswerteeinheit aufweist, die von der ersten Verknüpfungseinheit die mit dem Zeitsignal zugeordneten digitalen Messdaten empfängt, wobei die erste Auswerteeinheit ausgebildet ist, die digitalen Messdaten mit weiteren digitalen Messdaten zu verknüpfen und/oder die digitalen Messdaten mittels einer mathematischen Funktion zu verarbeiten, um somit erste abgeleitete Daten zu generieren, die der Sucheinheit zuführbar sind. Dadurch kann beispielsweise der technische Vorteil bewirkt werden, dass die der Sucheinheit zugeführten ersten abgeleiteten Daten derart aufbereitet bzw. verknüpft bzw. verarbeitet sind, dass die Suche auf das Eintreten eines oder mehrerer vorbestimmter Ereignisse vereinfacht oder beispielsweise erst ermöglicht wird. So können beispielsweise aus einer Mehrzahl an bereitgestellten digitalen Messdaten jeweils ein Mittelwert gebildet werden, die der Sucheinheit dann als erste abgeleitete Daten zugeführt werden, so dass die Sucheinheit in Summe eine geringere Anzahl an Daten bei der Suche verarbeiten muss. Alternativ ist es beispielweise erforderlich, dass aus den seitens des Messumsetzers bereitgestellten digitalen Messdaten der Spannung und der Stromstärke zunächst durch Multiplikation des Spannungswerts mit dem Wert der Stromstärke eine elektrische Leistung errechnet wird, die der Sucheinheit dann als erste abgeleitete Daten zugeführt wird, sofern das oder die mehreren vorbestimmten Ereignisse anhand eines Werts der elektrischen Leistung mittels der Sucheinheit auffindbar sind.

Nach einer weiteren vorteilhaften Ausführungsform der Busklemme ist vorgesehen, dass die Prozessoreinrichtung eine zweite Auswerteeinheit aufweist, die von der Sucheinheit die Ereignisdaten empfängt, wobei die zweite Auswerteeinheit ausgebildet ist, die Ereignisdaten mit weiteren Ereignisdaten und/oder mit weiteren digitalen Messdaten zu verknüpfen und/oder die Ereignisdaten mittels einer mathematischen Funktion zu verarbeiten, um somit zweite abgeleitete Daten zu generieren, die der zweite Verknüpfungseinheit zuführbar sind.

Dadurch kann beispielsweise der technische Vorteil bewirkt werden, dass die der zweiten Verknüpfungseinheit zugeführten zweiten abgeleiteten Daten derart aufbereitet bzw. verknüpft bzw. verarbeitet sind, dass die Verknüpfung der zweiten abgeleiteten Daten mit dem Zeitstempel vereinfacht oder beispielweise erst ermöglicht wird. Sofern seitens der Busklemme beispielsweise eine sehr genaue Nulldurchgangsbestimmung durchgeführt werden soll, würde seitens der Sucheinheit als Ereignis beispielsweise ein Vorzeichenwechsel innerhalb der von dem Messumsetzer bereitgestellten digitalen Messdaten gesucht. Sofern dann ein Vorzeichenwechsel innerhalb der Messdaten eintritt, würde die Sucheinheit der zweiten Auswerteeinheit den digitalen Messwert unmittelbar vor dem Vorzeichenwechsel und den digitalen Messwert unmittelbar nach dem Vorzeichenwechsel weiterleiten. Die zweite Auswerteeinheit würde dann beispielsweise mittels einer linearen Approximation aus dem digitalen Messwert und dem zugehörigen Zeitsignal vor dem Vorzeichenwechsel und dem digitalen Messwert und dem zugehörigen Zeitsignal nach dem Vorzeichenwechsel den genauen Nulldurchgang mit zugehörigem abgeleiteten Zeitsignal berechnen bzw. generieren und diese Daten dann als zweite abgeleitete Daten der zweiten Verknüpfungseinheit zuführen.

Mittels der ersten Auswerteeinheit generierte erste abgeleitete Daten und/oder mittels der zweiten Auswerteeinheit generierte zweite abgeleitete Daten können beispielsweise umfassen: einen Effektivwert einer gemessenen elektrischen Spannung, einen Effektivwert eines gemessenen elektrischen Stroms, einen Effektivwert einer Außenleiterspannung, eine Wirkleistung, eine Scheinleistung, eine Blindleistung, einen Leistungsfaktor beziehungsweise einen Powerfaktor, eine Frequenz, eine harmonische Oberschwingung der Strangspannungen und der Strangströme, eine Wirkenergie je Phase, eine gesamte Wirkenergie, ein Mittelwert einer Scheinleistung und/oder einer Blindleistung.

Nach einer Ausführungsform der erfindungsgemäßen Busklemme ist vorgesehen, dass die Prozessoreinrichtung sowohl eine erste Auswerteeinheit, als auch eine zweite Auswerteeinheit aufweist.

Nach einer anderen vorteilhaften Ausführungsform ist vorgesehen, dass das oder die mehreren vorbestimmten Ereignisse beispielsweise ausgewählt sind aus der folgenden Gruppe von Ereignissen:

ein Spannungsabfall im Versorgungsstromnetz unter einen vorbestimmten Spannungsschwellwert,
ein Spannungsanstieg im Versorgungsstromnetz über einen vorbestimmten Spannungsschwellwert,
ein Stromabfall im Versorgungsstromnetz unter einen vorbestimmten Stromschwellwert,
ein Stromanstieg im Versorgungsstrom über einen vorbestimmten Stromschwellwert,
ein zeitlicher Verlauf einer gemessenen elektrischen Größe entspricht einem vorbestimmten zeitlichen Soll-Verlauf oder weicht von diesem ab und/oder das Auftreten eines Nulldurchgangs einer Phase bei einem als Wechselstromnetz ausgebildeten Versorgungsstromnetz.

Insbesondere ist vorgesehen, dass das oder die mehreren vorbestimmten Ereignisse ausgewählt sind aus der folgenden Gruppe von Ereignissen:

eine elektrische Überspannung im Versorgungsstromnetz,
ein elektrischer Überstrom im Versorgungsstromnetz,
ein Maximalwert beziehungsweise Minimalwert einer Wirkleistung,
ein Maximalwert eines Stromeingangs,
ein Minimalwert beziehungsweise Maximalwert eines Effektivwerts eines gemessenen elektrischen Stroms und/oder
ein Minimalwert beziehungsweise Maximalwert eines Effektivwerts einer gemessenen elektrischen Spannung.

Dadurch wird zum Beispiel der technische Vorteil bewirkt, dass der oder die für die Überwachung relevanten Parameter effizient ermittelt werden.

Nach einer Ausführungsform ist vorgesehen, dass die Busklemme einen Speicher umfasst zum Speichern eines oder mehrerer Programme zum Untersuchen mittels der Sucheinheit, zum Generieren von ersten abgeleiteten Daten mittels der ersten Auswerteeinheit und/oder zum Generieren von zweiten abgeleiteten Daten mittels der zweiten Auswerteeinheit, wobei die Prozessoreinrichtung ausgebildet ist das oder die Programme aus dem Speicher auszulesen und auszuführen, wobei die Kommunikationsschnittstelle ausgebildet ist, das oder die Programme und/oder Aktualisierungsdaten für das oder die Programme über das Kommunikationsnetzwerk zu empfangen, wobei die Prozessoreinrichtung ausgebildet ist, das oder die empfangenen Programme in dem Speicher zu speichern und/oder das oder die Programme basierend auf den Aktualisierungsdaten zu aktualisieren.

Dadurch wird zum Beispiel der technische Vorteil bewirkt, dass die Busklemme auch im eingebauten Zustand mit einem oder mehreren aktualisierten Programmen versehen werden kann. Insbesondere wird dadurch der technische Vorteil bewirkt, dass die Busklemme entfernt über das Kommunikationsnetzwerk programmiert werden kann. Insbesondere wird dadurch der technische Vorteil bewirkt, dass ein Endnutzer der Busklemme diese nach seinen eigenen Bedürfnissen programmieren kann. Dadurch wird insbesondere eine hohe Flexibilität hinsichtlich der Überwachung des Versorgungsstromnetzes bewirkt. Für den Endnutzer ist die Busklemme somit keine "Black Box", die er nicht selbst programmieren kann, sondern die er frei konfigurieren bzw. programmieren kann.

In einer Ausführungsform ist vorgesehen, dass das Versorgungsstromnetz ein mehrphasiges Wechselstromnetzwerk ist.

Beispielsweise ist das mehrphasige Wechselstromnetzwerk ein dreiphasiges Wechselstromnetzwerk.

Das Kommunikationsnetzwerk ist gemäß einer Ausführungsform ein EtherCAT-Kommunikationsnetzwerk.

Die Kommunikationsschnittstelle ist gemäß einer Ausführungsform eine EtherCAT-Kommunikationsschnittstelle.

Die EtherCAT-Kommunikationsschnittstelle ist gemäß einer Ausführungsform ausgebildet, die Nutzdaten in ein EtherCAT-Telegramm einzufügen.

In einer Ausführungsform umfasst das Synchronisieren ein Synchronisieren gemäß der "Distributed Clock"-Spezifikation gemäß "Hardware Data Sheet Section 1 EtherCAT Slave Controller; Version 2.3; Datum 21. Februar 2017; Abschnitt I; Unterabschnitt 9. "Distributed Clocks", Seiten I-52 bis I-74, https://download.beckhoff.com/download/document/io/ethercatdevelopment-products/ethercat esc datasheet sec1 technology 2i3.pdf, Beckhoff Automation GmbH & Ko. KG".

Die Offenlegungsschrift DE 10 2014 105 211 A1 offenbart ebenfalls ein Verfahren, welches über eine Synchronisation mehrerer verteilter Uhren eine hohe Zeitauflösung in einem Kommunikationsnetzwerk ermöglicht. Der Inhalt der genannten Offenlegungsschrift wird durch Bezugnahme vollumfänglich auch zum Gegenstand dieser Offenbarung gemacht.

Gemäß einer Ausführungsform ist vorgesehen, dass die Busklemme ausgebildet oder eingerichtet ist, das Verfahren zum Überwachen eines Versorgungsstromnetzes eines Automatisierungssystems aus- oder durchzuführen.

Technische Funktionalitäten der Busklemme ergeben sich analog aus entsprechenden technischen Funktionalitäten des Verfahrens und umgekehrt.

Die Prozessoreinrichtung umfasst gemäß einer Ausführungsform einen Mikrocontroller, beispielsweise einen ARM-Mikrocontroller. Der Mikrocontroller umfasst gemäß einer Ausführungsform eine "Floating Point Unit (FPU)", also eine Gleitkommaeinheit.

Gemäß einer Ausführungsform umfassen die eine oder die mehreren elektrischen Größen eine elektrische Spannung und/oder einen elektrischen Strom.

Sofern das Versorgungsstromnetz ein mehrphasiges Wechselstromnetz ist, ist gemäß einer Ausführungsform vorgesehen, dass für eine oder für mehrere oder für alle der Phasen des mehrphasigen Versorgungsstromnetzes die eine oder die mehreren elektrischen Größen gemessen werden. Das heißt also insbesondere, dass beispielsweise je Phase eine oder mehrere elektrische Größen gemessen werden.

In einer Ausführungsform ist das Versorgungsstromnetz ein Verbundnetz oder ein Inselnetz.

Die Erfindung wird im Folgenden anhand von bevorzugten Ausführungsbeispielen näher erläutert. Hierbei zeigen

Fig. 1 eine erste Busklemme,

Fig. 2 ein Ablaufdiagramm eines Verfahrens zum Überwachen eines Versorgungsstromnetzes mittels der ersten Busklemme,

Fig. 3 eine zweite Busklemme,

Fig. 4 ein Ablaufdiagramm eines Verfahrens zum Überwachen eines Versorgungsstromnetzes mittels der zweiten Busklemme,

Fig. 5 eine dritte Busklemme,

Fig. 6 ein Ablaufdiagramm eines Verfahrens zum Überwachen eines Versorgungsstromnetzes mittels der dritten Busklemme,

Fig. 7 eine Nulldurchgangsbestimmung,

Fig. 8 eine vierte Busklemme,

Fig. 9 ein Ablaufdiagramm eines Verfahrens zum Überwachen eines Versorgungsstromnetzes mittels der vierten Busklemme,

Fig. 10 ein erstes Versorgungsstromnetz und

Fig. 11 ein zweites Versorgungsstromnetz.

Im Folgenden werden für gleiche Merkmale innerhalb der Figuren gleiche Bezugszeichen verwendet.

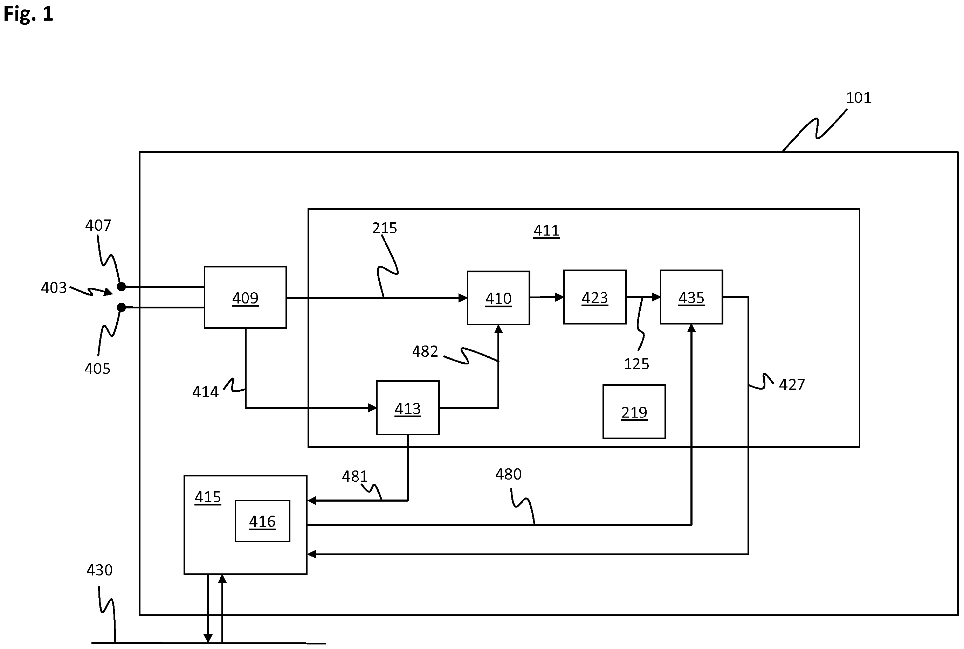

Fig. 1 zeigt eine erste Busklemme 101 eines Automatisierungssystems (nicht gezeigt) zum Überwachen eines Versorgungsstromnetzes 403.

Das Automatisierungssystem verfügt über ein Kommunikationsnetzwerk 430, das auch als Feldbussystem bezeichnet werden kann, mittels dessen Kommunikationsdaten, die auch als Feldbusdaten bezeichnet werden können, zwischen den einzelnen Teilnehmern des Automatisierungssystems ausgetauscht werden können.

Bei dem Kommunikationsnetzwerk 430 handelt es sich beispielsweise um ein Kommunikationsnetzwerk 430 nach dem EtherCAT-Standard beispielsweise entsprechend der Norm IEC 61158-3/4/5/6-12.

Diesbezüglich verfügt die erste Busklemme 101 über eine Kommunikationsschnittstelle 415, beispielsweise eine EtherCAT-Kommunikationsschnittstelle, die beispielsweise als ein EtherCAT-ASIC (ASIC: "Application Specific Integrated Circuit"; anwendungsspezifische integrierte Schaltung) ausgebildet ist, zum Kommunizieren über ein Kommunikationsnetzwerk 430 des Automatisierungssystems.

Die Kommunikationsschnittstelle 415 ist ausgebildet, über das Kommunikationsnetzwerk 430 eine Referenzzeit zu empfangen. Die Referenzzeit wird beispielsweise gemäß der "Distributed Clock"-Spezifikation gemäß "Hardware Data Sheet Section 1 EtherCAT Slave Controller; Version 2.3; Datum 21. Februar 2017; Abschnitt I; Unterabschnitt 9. "Distributed Clocks", Seiten I-52 bis I-74, https://download.beckhoff.com/download/document/io/ethercat-development-products/ethercat esc datasheet secl technology 2i3.pdf, Beckhoff Automation GmbH & Ko. KG" von einem Teilnehmer des Kommunikationsnetzwerkes 430 erzeugt und dann entsprechend dem beschriebenen und aus dem Stand der Technik bekannten Verfahren in dem Kommunikationsnetzwerk verteilt.

Die Kommunikationsschnittstelle 415 bzw. der EtherCAT-ASIC verfügt über eine erste Uhr 416. Insbesondere ist die Kommunikationsschnittstelle 415 ausgebildet, die Uhrzeit der ersten Uhr 416 auf die Referenzzeit zu synchronisieren.

Die Busklemme 101 umfasst ferner einen als Analog-Digital-Umsetzer ausgebildeten Messumsetzer 409 zum Messen einer oder mehrerer elektrischer Größen des Versorgungsstromnetzes 403. Das Versorgungsstromnetz 403 ist beispielsweise ein Wechselstromnetz und umfasst mehrere Phasen, wobei der Übersicht halber hier nur eine Phase 407 dargestellt ist. Das Versorgungsstromnetz 403 umfasst einen Nullleiter 405.

Beispielsweise misst der Messumsetzer 409 eine elektrische Spannung und/oder einen elektrischen Strom, insbesondere eine elektrische Spannung zwischen der Phase 407 und dem Nullleiter 405.

Der Messumsetzer 409 stellt zu der einen oder den mehreren gemessenen elektrischen Größe entsprechende digitale Messdaten 215 bereit.

Die erste Busklemme 101 umfasst eine Prozessoreinrichtung 411, die eine zweite Uhr 413 umfasst. Sobald der Messumsetzer 409 neue digitale Messdaten 215 bereitstellt, führt er zusätzlich der zweiten Uhr 413 ein entsprechendes Bereitstellungssignal 414 zu. Daraufhin generiert die zweite Uhr 413 ein Zeitsignal 482. Bei dem Zeitsignal 482 handelt es sich beispielsweise nicht um eine absolute Zeitangabe innerhalb eines größeren Systems, sondern um eine relative Zeitangabe in Bezug auf die zweite Uhr 413. Beispielsweise ist die zweite Uhr 413 ein einfacher Timer, der beispielsweise innerhalb einer Sekunde fünftausend Zeitsignale generieren kann. Die beschriebene Zeitauflösung, also die Anzahl der Zeitsignale je Zeiteinheit, insbesondere je Sekunde, dient nur der Vereinfachung. In einer vorteilhaften Ausführungsform kann diese Zeitauflösung viel höher sein, beispielsweise 100ns, was zehn Millionen Zeitsignalen pro Sekunde entspricht. Nach diesen fünftausend Zeitsignalen beginnt der Timer erneut bei Null an zu zählen, bis er erneut bei Fünftausend angelangt ist.

Weiterhin ist die zweite Uhr 413 ausgebildet, die erste Uhr 416 zu veranlassen, periodisch die synchronisierte Uhrzeit 480 bereitzustellen. Dazu übermittelt die zweite Uhr 413 beispielsweise immer zum Start der fünftausend Zeitsignale ein Uhrzeitbereitstellungssignal 481 an die erste Uhr. Dieses Uhrzeitbereitstellungssignal 481 ist zum Beispiel eine 1-Bit-Nachricht. Gemäß dem beschriebenen Beispiel würde also jede Sekunde ein entsprechendes Uhrzeitbereitstellungssignal 481 von der zweiten Uhr 413 an die erste Uhr 416 übermittelt werden.

Des Weiteren umfasst die Prozessoreinrichtung 411 eine erste Verknüpfungseinheit 410. Die erste Verknüpfungseinheit 410 ist ausgebildet, den digitalen Messdaten 215 das von der zweiten Uhr generierte Zeitsignal 482 zuzuordnen. Dieses Zeitsignal 482 bezieht sich dann auf die Messdaten 215 und wird, wie beschrieben, erzeugt sobald das Bereitstellungsignal 414 der zweiten Uhr 413 zugeführt wird. Beispielsweise werden die Messdaten 215 zu einem Zeitpunkt X bereitgestellt. Der Messumsetzer 409 generiert dann das Bereitstellungssignal 414 und führt dieses der zweiten Uhr 413 zu. Wenn die zweite Uhr 413 in dem Moment dann beispielsweise beim Zählerwert Eintausendzweihundertfünfzig steht, übermittelt die zweite Uhr 413 den Wert Eintausendzweihundertfünfzig als Zeitsignal 482 an die erste Verknüpfungseinheit 410. Diese verknüpft die erzeugten Messdaten 215 dann mit dem Zeitsignal 482, also dem Wert Eintausendzweihundertfünfzig.

Weiterhin umfasst die erste Busklemme 101, insbesondere die Prozessoreinrichtung 411, eine Sucheinheit 423. Die Sucheinheit 423 ist ausgebildet, die seitens der ersten Verknüpfungseinheit 410 zugeführten digitalen Messdaten 215 auf das Eintreten eines oder mehrerer vorbestimmter Ereignisse hin zu untersuchen. Bei dem vorbestimmten Ereignis kann es sich beispielsweise um eine maximale Spannung innerhalb einer festgelegten Anzahl von Messdaten 215 handeln. Basierend auf der Feststellung des Vorliegens des oder der vorbestimmten Ereignisse innerhalb der Messdaten 215 werden dann seitens der Sucheinheit 423 Ereignisdaten 125 generiert. Diese Ereignisdaten 125 könnten beispielsweise nur die Messdaten 215 des maximalen Spannungswertes innerhalb der festgelegten Anzahl umfassen, da nur diese Daten in Bezug auf das vorbestimmte Ereignis für das weitere Vorgehen von Interesse sind.

Die Prozessoreinrichtung 411 umfasst weiterhin eine zweite Verknüpfungseinheit 435. Die zweite Verknüpfungseinheit 435 empfängt die Ereignisdaten 125, die selbstverständlich die entsprechenden, innerhalb der ersten Verknüpfungseinheit 410 zugeordneten Zeitsignale 482 umfassen. Die zweite Verknüpfungseinheit 435 versieht die Ereignisdaten 125 dann mit einem Zeitstempel, wobei der Zeitstempel auf einer Verknüpfung der von der ersten Uhr bereitgestellten synchronisierten Uhrzeit 480 und dem den digitalen Messdaten 215 des Ereignisses zugeordneten Zeitsignal basiert. Die synchronisierte Uhrzeit 480 besteht beispielsweise aus einem Datum und einer entsprechenden, beispielweise Nanosekunden-genauen globalen Uhrzeit, also der Referenzzeit. Das dem Ereignis, im oben genannten Beispiel die maximale Spannung innerhalb einer festgelegten Anzahl von Messdaten 215, zugeordnete Zeitsignal 482 ist der Wert Eintausendzweihundertfünfzig. Da wie beschrieben bekannt ist, dass die zweite Uhr 413 immer zum Start ihrer fünftausend Zeitsignale innerhalb einer Sekunde das Uhrzeitbereitstellungssignal 481 an die erste Uhr 416 übermittelt, und das Zeitsignal den Wert eintausendzweihundertfünfzig aufweist, wurde der maximale Wert der Spannung innerhalb der festgelegten Anzahl von Messdaten eintausendzweihundertfünfzig fünftausendstel Sekunden nach dem Übermitteln des letzten Uhrzeitbereitstellungssignals 481 gemessen. Somit kann dieser Wert dann mit der synchronisierten Uhrzeit 480 verknüpft werden, indem beispielsweise Nullkommazweifünf Sekunden auf die synchronisierte Uhrzeit 480 addiert werden. Diese verknüpfte Uhrzeit bildet dann den Zeitstempel für den Moment der maximalen Spannung. Die so mit dem Zeitstempel verknüpften Ereignisdaten 125 werden als Nutzdaten 427 an die Kommunikationsschnittstelle 415 übermittelt, die ausgebildet ist, die Nutzdaten 427 über das Kommunikationsnetz 430 zu senden.

Somit stehen beispielsweise einer Steuerung des Automatisierungssystems die Nutzdaten 427 der ersten Busklemme 101 zur Verfügung, die mit einer für das gesamte Automatisierungssystem vergleichbaren Zeitinformation, dem Zeitstempel, versehen sind. Dies deshalb, da dieser Zeitstempel basierend auf der Referenzzeit ermittelt wurde.

Mit einem analog ermittelten Zeitstempel versehene Nutzdaten von anderen Busklemmen des Automatisierungsnetzwerks können somit zeitlich untereinander verglichen werden. Insbesondere können diese Nutzdaten der Busklemmen aufgrund der einheitlichen Zeitbasis in eine zeitliche Reihenfolge gebracht werden.

Die Steuerung kann somit in vorteilhafter Weise effizient die Nutzdaten der Busklemmen für weitere Diagnose- und/oder Regelungsprozesse verwenden.

Die Prozessoreinrichtung 411 umfasst gemäß einer Ausführungsform einen Mikrocontroller, beispielsweise einen ARM-Mikrocontroller. Der Mikrocontroller umfasst beispielsweise eine "Floating Point Unit (FPU)", also eine Gleitkommaeinheit.

Die Prozessoreinrichtung 411 umfasst einen Speicher 219, in welchem beispielsweise ein Programm zum Untersuchen der bereitgestellten digitalen Messdaten 215 mittels der Sucheinheit 423 gespeichert ist. Die Prozessoreinrichtung 411 führt zum Untersuchen der digitalen Messdaten 215 das Programm aus.

Die Kommunikationsschnittstelle 415 ist ausgebildet, über das Kommunikationsnetzwerk 430 Aktualisierungsdaten für das Programm oder die Programme zu empfangen. Beispielsweise ist die Kommunikationsschnittstelle 415 ausgebildet, ein Programm zum Untersuchen über das Kommunikationsnetzwerk 430 zu empfangen. Die Prozessoreinrichtung 411 aktualisiert dann beispielsweise das Programm basierend auf den Aktualisierungsdaten. Die Prozessoreinrichtung 411 speichert zum Beispiel das empfangene Programm in dem Speicher 219.

Somit ist es in vorteilhafter Weise ermöglicht, über das Kommunikationsnetzwerk 430 die erste Busklemme 101 neu zu programmieren. Es ist somit auch in vorteilhafter Weise durch einen Endanwender bzw. Endnutzer ermöglicht, auf den konkreten Einzelfall angepasste Auswertungen der gemessenen elektrischen Größen vorzunehmen.

Hier wiesen bisher übliche Busklemmen oder andere Einheiten zum Messen von elektrischen Größen eines Versorgungsstromnetzes den Nachteil auf, dass diese als sogenannte "Black Box" ausgebildet waren, die eine vom Hersteller fest vorgegebene Auswertung der gemessenen Größen vorgenommen haben, ohne dass ein Endnutzer selbst Einfluss darauf nehmen konnte beziehungsweise die Auswertung ändern konnte.

Weiter wiesen bisher übliche Busklemmen den Nachteil auf, dass eine genaue zeitliche Zuordnung der gemessenen beziehungsweise ausgewerteten Größen nicht möglich war. Dies deshalb nicht, da bisher übliche Busklemmen ihre interne Uhr nicht mit einer Referenzzeit synchronisierten oder weil der Zeitpunkt der Messung und der zeitliche Einfluss der Auswertung nicht bekannt war.

Durch die erfindungsgemäße Busklemme gewinnt ein Endanwender eine größere Flexibilität und Skalierbarkeit hinsichtlich der Verwendung beziehungsweise der Überwachung des Versorgungsstromnetzes.

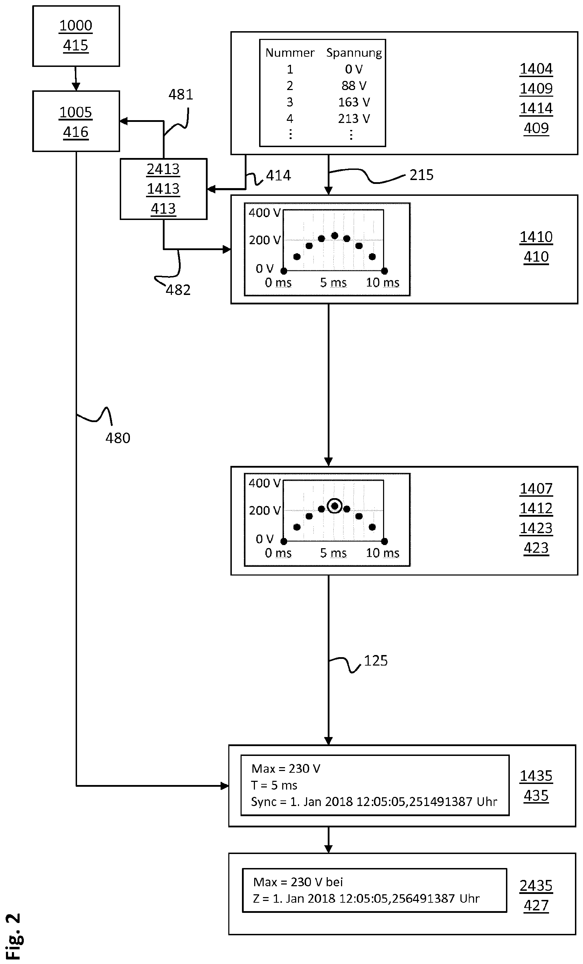

Fig. 2 zeigt ein schematisiertes, beispielhaftes Ablaufdiagramm eines Verfahrens zum Überwachen eines Versorgungsstromnetzes unter Verwendung der ersten Busklemme 101.

Zum besseren Verständnis weisen die einzelnen Blöcke des Verfahrens gemäß Figur 2 teilweise zusätzlich die Bezugszeichen der entsprechenden, zugehörigen Vorrichtungen gemäß Figur 1 auf. Zusätzlich werden in der folgenden Beschreibung entsprechende, in Figur 1 verwendete Bezugszeichen genannt.

Das Verfahren startet mit dem Empfangen 1000 einer Referenzzeit über das Kommunikationsnetzwerk 430 seitens der Kommunikationsschnittstelle 415. Mittels dieser Referenzzeit erfolgt ein Synchronisieren 1005 der Uhrzeit der ersten Uhr 416.

Parallel erfolgt in dem dargestellten Beispiel mittels des Messumsetzers 409 ein Messen 1404 einer elektrischen Größe des Versorgungsstromnetzes 403, in dem Fall ein Messen 1404 einer elektrischen Spannung einer Phase 407 des Versorgungsstromnetzes 403. Das Messen 1404 wird in Figur 2 durch eine Tabelle symbolisiert in der fortlaufend Messdaten geschrieben werden. Die Messdaten werden dabei in der Figur 2 einer Nummer zugeordnet, die die Reihenfolge der Messdaten symbolisiert. Die einzelnen Spannungswerte werden seitens des Messumformers 409 bereitgestellt 1409. Beispielsweise wird als erstes Messdatum 215 ein Spannungswert von 0V, als zweites Messdatum 215 ein Spannungswert von 88V, als drittes Messdatum 215 ein Spannungswert von 163V, als viertes Messdatum 215 ein Spannungswert von 213V und so weiter bereitgestellt 1409. Die bereitgestellten digitalen Messdaten 215 werden einzeln an die erste Verknüpfungseinheit 410 übermitteln. Gleichzeitig mit dem Bereitstellen 1409 und Übermitteln der digitalen Messdaten erfolgt für jedes Messdatum 215 jeweils ein Zuführen 1414 eines Bereitstellungssignals 414 seitens des Messumformers 409 an die zweite Uhr 413. Die zweite Uhr 413 generiert 1413 daraufhin ein Zeitsignal 482, welches die zweite Uhr 413 der ersten Verknüpfungseinheit 410 zuführt. Bei dem Zeitsignal 482 handelt es sich beispielsweise nicht um eine absolute Zeitangabe innerhalb eines größeren Systems, sondern um eine relative Zeitangabe in Bezug auf die zweite Uhr 413. Wie in Bezug auf Figur 1 bereits beschrieben, ist die zweite Uhr 413 beispielsweise ein einfacher Timer, der beispielsweise innerhalb einer Sekunde fünftausend Zeitsignale generieren kann. Nach diesen fünftausend Zeitsignalen beginnt der Timer erneut bei Null an zu zählen, bis er erneut bei Fünftausend angelangt ist.

In der ersten Verknüpfungseinheit 410 erfolgt dann ein Zuordnen 1410 der digitalen Messdaten 215 zu den Zeitsignalen 482. Somit wird beispielsweise ein Spannungs-/Zeitdiagramm erstellt, welches im dargestellten Beispiel pro einskommazweifünf Millisekunden einen Spannungswert enthält. Dies entspricht einer Datenbereitstellungsrate von 800 Messdaten pro Sekunden. Diese Datenbreitstellungsrate dient nur zur Veranschaulichung des Verfahrens. In einer vorteilhaften Ausführungsform kann die Datenbereitstellungsrate viel höher beispielsweise bei neuntausendsiebenhundert Messdaten pro Sekunde oder beispielsweise zwischen achttausend Messdaten pro Sekunde und zwölftausend Messdaten pro Sekunde liegen.

In einem nächsten Schritt erfolgt eine Untersuchung 1423 der digitalen Messdaten 215 auf ein vorbestimmtes Ereignis hin. In dem dargestellten Beispiel wird beispielsweise ein maximaler Spannungswert als vorbestimmtes Ereignis gesucht. Also untersucht 1423 die Sucheinheit 423 die bereitgestellten digitalen Messdaten 215 auf einen maximalen Wert hin. Das Auffinden des maximalen Spannungswertes also das Eintreten 1407 des vorbestimmten Ereignisses im Rahmen der Untersuchung 1423 ist in der Figur 2 durch einen Kreis um den entsprechenden Wert markiert und versinnbildlicht. Aufgrund des Eintretens 1423 des vorbestimmten Ereignisses erfolgt ein Generieren 1412 von auf den Messdaten 215 basierenden Ereignisdaten 125. Da das Ereignis des maximale Spannungswert von 230V, in Figur 2 mit der Bezeichnung Max gekennzeichnet, ist und diesem maximale Spannungswert das Zeitsignal 482 von 5ms, in Figur 2 mit der Bezeichnung T gekennzeichnet, zugeordnet ist, bestehen die Ereignisdaten 125 in diesem Fall aus den beiden Werten 230V und 5ms, die dann der zweiten Verknüpfungseinheit 435 zugeführt werden. Alternativ ist es jedoch auch möglich, dass die Ereignisdaten 125 eine zusätzliche Information enthalten, auf welchem gesuchten Ereignis bzw. auf welchen gesuchten Ereignissen die Ereignisdaten 125 basieren. In dem genannten Beispiel wäre die zusätzliche Information dann eine Information in Bezug auf den gesuchten maximalen Spannungswert.

Unabhängig von den bzw. parallel zu den zuvor beschriebenen Verfahrensschritten erfolgt eine periodische Veranlassung 2413 der ersten Uhr 416 seitens der zweiten Uhr 413, die synchronisierte Uhrzeit 480 bereitzustellen. Diese periodische Veranlassung 2413 erfolgt beispielsweise immer zum Start des Zählens der fünftausend Zeitsignale der zweiten Uhr 413 durch ein Übermitteln eines Uhrzeitbereitstellungssignals 481 an die erste Uhr 416. Gemäß dem oben beschriebenen Beispiel würde also jede Sekunde ein entsprechendes Uhrzeitbereitstellungssignal 481 von der zweiten Uhr 413 an die erste Uhr 416 übermittelt. Aufgrund dieser Veranlassung 2413 wird die synchronisierte Uhrzeit 480 der zweiten Verknüpfungseinheit 435 zugeführt. In dem in Figur 2 dargestellten Beispiel lautet die synchronisierte Uhrzeit 480: 1. Januar 2018; 12:05:05,251491387 Uhr, welche in der Figur 2 mit dem Begriff Sync gekennzeichnet ist.

In der zweiten Verknüpfungseinheit 435 erfolgt dann ein Versehen 1435 der Ereignisdaten 125 mit einem Zeitstempel. Dieser Zeitstempel basiert, wie beschrieben, auf einer Verknüpfung der von der ersten Uhr 416 bereitgestellten synchronisierten Uhrzeit 480 und dem den digitalen Messdaten 215 des Ereignisses zugeordneten Zeitsignal 482. Gemäß dem Beispiel wird also die synchronisierte Uhrzeit 480 mit dem Wert 1. Januar 2018; 12:05:05,251491387 Uhr mit dem Wert des Zeitsignals 482 an dem das gesuchte Ereignis, also der maximale Spannungswert, eingetreten ist, also gemäß dem Beispiel der Wert 5ms addiert. Somit ergibt sich ein Zeitstempel, in Figur 2 gekennzeichnet mit dem Buchstaben Z, mit dem Wert: 1. Januar 2018; 12:05:05,256491387 Uhr.

Mittels des Versehens 1435 der Ereignisdaten 125 mit dem Zeitstempel erfolgt ein Generieren 2435 von Nutzdaten 427, die dann in einem abschließenden, hier nicht dargestellten Verfahrensschritt über das Kommunikationsnetzwerk 430 gesendet werden.

Sofern die beschriebenen Verfahrensschritte mehrfach nacheinander durchgeführt wurden, besteht bei einer nicht dargestellten Ausführungsform des erfindungsgemäßen Verfahrens unter Nutzung einer erfindungsgemäßen Busklemme die zusätzliche Möglichkeit, eine fehlerfreie Funktionsweise der zweiten Uhr 413 zu überprüfen. Beispielsweise könnte es vorkommen, dass sich der Timer der zweiten Uhr 413 derart verstellt, dass er die beschriebenen fünftausend Zeitsignale nicht innerhalb einer Sekunde erzeugt, sondern hierfür eine kürzere oder eine längere Zeitdauer in Anspruch nimmt. Beispielhaft sei angenommen, dass die zweite Uhr 413 für das Zählen der fünftausend Zeitsignale einskommazwei Sekunden benötigt. Somit wird auch nur alle einskommazwei Sekunden ein Uhrzeitbereitstellungssignal 481 an die erste Uhr 416 übermittelt. Da das dem Ereignis zugeordnete Zeitsignal 482 jedoch nur relativ in Bezug auf die fünftausend Zeitsignale innerhalb einer Zählperiode abgebildet wird, würde sich somit bei der Verknüpfung der synchronisierten Uhrzeit mit dem Zeitsignal eine Ungenauigkeit in Bezug auf den Zeitstempel ergeben. Um diesem entgegenzuwirken, kann bei der nicht dargestellten Ausführungsform vorgesehen sein, dass der Quotient aus dem dem Ereignis zugeordneten Zeitsignal und der Gesamtheit der Zeitsignale innerhalb einer Zählperiode mit der Differenz aus der übermittelten synchronisierten Uhrzeit des vorherigen Überwachungsintervalls und der synchronisierten Uhrzeit des aktuellen Überwachungsintervalls multipliziert wird. Dieses Produkt wird dann zu der synchronisierten Uhrzeit des aktuellen Überwachungsintervalls addiert, so dass die Summe den Zeitstempel bildet.

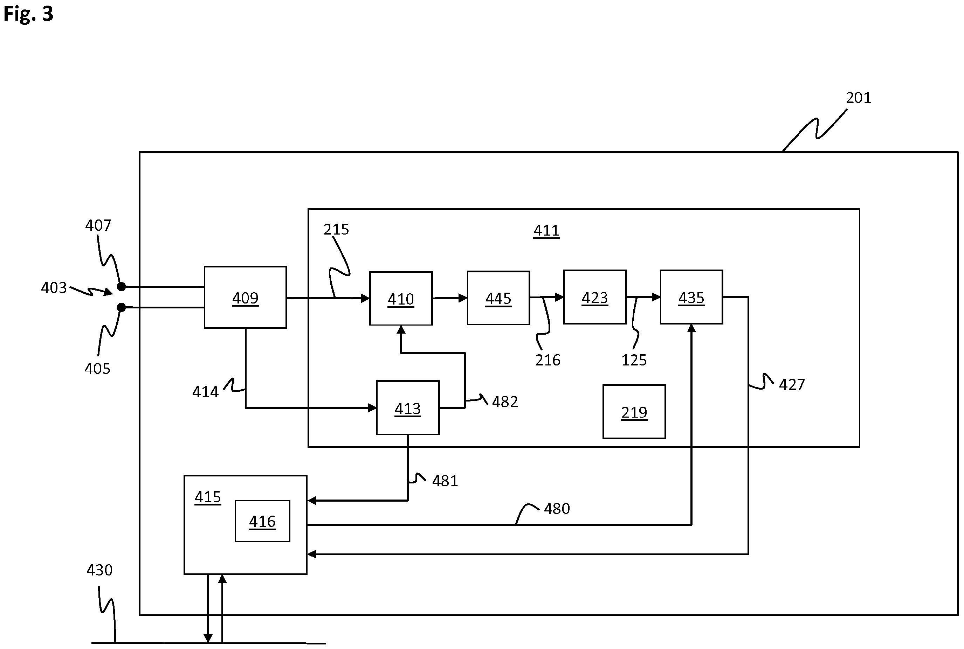

Fig. 3 zeigt eine zweite Busklemme 201 eines Automatisierungssystems (nicht gezeigt) zum Überwachen eines Versorgungsstromnetzes 403.

Die zweite Busklemme 201 entspricht im Aufbau und der Funktionsweise in wesentlichen Teilen dem Aufbau und der Funktionsweise der ersten Busklemme 101 gemäß Figur 1, so dass um Wiederholungen zu vermeiden im Folgenden nur auf die Unterschiede eingegangen wird.

Neben den zu Figur 1 beschriebenen Einheiten der ersten Busklemme 101 weist die zweite Busklemme 201, insbesondere die Prozessoreinrichtung 411 eine erste Auswerteeinheit 445 auf, welche funktional zwischen der ersten Verknüpfungseinheit 410 und der Sucheinheit 423 angeordnet ist. Die erste Auswerteeinheit 445 ist ausgebildet, die mit dem Zeitsignal 482 zugeordneten digitalen Messdaten 215 von der erste Verknüpfungseinheit 410 zu empfangen. Die digitalen Messdaten 215 werden dann seitens der ersten Auswerteeinheit 445 beispielsweise mit weiteren digitalen Messdaten 215 verknüpft und/oder die digitalen Messdaten 215 werden mittels einer mathematischen Funktion verarbeitet. Somit werden aus den digitalen Messdaten 215 erste abgeleitete Daten 216 generiert, die dann anstelle der digitalen Daten 215 an die Sucheinheit 423 übermittelt und analog zu der weiter oben beschriebenen Vorgehensweise in Bezug auf die digitalen Daten 215 weiterverarbeitet werden.

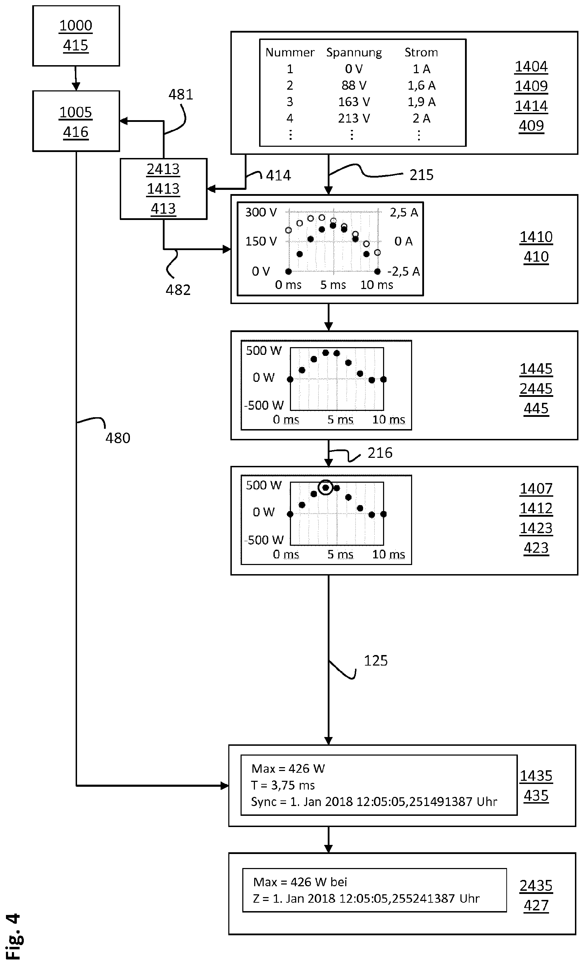

Fig. 4 zeigt ein schematisiertes, beispielhaftes Ablaufdiagramm eines Verfahrens zum Überwachen eines Versorgungsstromnetzes unter Verwendung der zweiten Busklemme 201.

Da die zweite Busklemme 201 im Aufbau und der Funktionsweise in wesentlichen Teilen dem Aufbau und der Funktionsweise der ersten Busklemme 101 gemäß Figur 1 entspricht, wird, um Wiederholungen zu vermeiden, im Folgenden nur auf die Unterschiede eingegangen.

In dem dargestellten Beispiel erfolgt mittels des Messumsetzers 409 ein Messen 1404 zweier elektrischen Größen des Versorgungsstromnetzes 403, in dem Fall ein Messen 1404 einer elektrischen Spannung und ein Messen einer Stromstärke einer Phase 407 des Versorgungsstromnetzes 403. Die einzelnen Spannungswerte und die einzelnen Stromstärkewerte werden seitens des Messumformers 409 bereitgestellt 1409. Beispielweise werden als erste Messdaten 215 ein Spannungswert von 0V und eine Stromstärke von 1A, als zweite Messdaten 215 ein Spannungswert von 88V und eine Stromstärke von 1,6A, als dritte Messdaten 215 ein Spannungswert von 163V und eine Stromstärke von 1,9A, als vierte Messdaten 215 ein Spannungswert von 213V und eine Stromstärke von 2A und so weiter bereitgestellt 1409. Die bereitgestellten digitalen Messdaten 215 werden einzeln an die erste Verknüpfungseinheit 410 übermitteln. Das weitere Verfahren erfolgt analog zu der Beschreibung zu Figur 2.

Ebenfalls analog zu dem Beispiel zu Figur 2 erfolgt in der ersten Verknüpfungseinheit 410 ein Zuordnen 1410 der digitalen Messdaten 215 zu den Zeitsignalen 482. In dem in Figur 4 dargestellten Beispiel wird aufgrund der Mehrzahl an gemessenen Größen ein kombiniertes Spannungs-/Stromstärke-Zeitdiagramm erstellt, welches im dargestellten Beispiel pro einskommazweifünf Millisekunden einen Spannungswert und einen Stromstärkewert enthält. Die Höhe der Spannung ist an der linken Ordinate aufgetragen und die einzelnen Spannungswerte sind als gefüllte Punkte in Figur 4 dargestellt. Die Höhe der Stromstärke ist an der rechten Ordinate aufgetragen und die einzelnen Stromstärkenwerte sind als nicht gefüllte Punkte in Figur 4 dargestellt. Auf der Abszisse ist die Zeit in Millisekunden aufgetragen, wobei sich die Zeit auf die Zeitsignale der zweiten Uhr 413 bezieht.

Die einzelnen digitalen Messwerten 215 für die Spannung und die Stromstärke werden dann seitens der ersten Auswerteeinheit 445 empfangen und diese werden dann miteinander verknüpft 1445. Im Rahmen der Verknüpfung 1445 werden die einzelnen Spannungswerte und Stromstärkenwerte der jeweiligen Zeitsignale miteinander multipliziert, um somit ein Leistungs-/Zeitdiagramm zu erzeugen. Mittels der einzelnen Werte der Leistung zu den jeweiligen Zeitsignalen werden dann erste abgeleitete Daten 216 generiert 2445, die dann der Sucheinheit 423 zugeführt werden.

Die ersten abgeleiteten Daten 216 werden dann in der Sucheinheit 423 und in den nachfolgenden Verfahrensschritten analog zu den im Zusammenhang mit Figur 1 beschriebenen digitalen Messdaten 215 behandelt.

In dem Bespiel gemäß Figur 4 erfolgt in einem nächsten Schritt eine Untersuchung 1423 der ersten abgeleiteten Daten 216 auf ein vorbestimmtes Ereignis hin. In dem dargestellten Beispiel wird beispielsweise ein maximaler Leistungswert als vorbestimmtes Ereignis gesucht. Also untersucht 1423 die Sucheinheit 423 die ersten abgeleiteten Daten 216 auf einen maximalen Wert hin. Das Auffinden des maximalen Leistungswertes also das Eintreten 1407 des vorbestimmten Ereignisses im Rahmen der Untersuchung 1423 ist in der Figur 4 durch einen Kreis um den entsprechenden Wert markiert und versinnbildlicht. Aufgrund des Eintretens 1423 des vorbestimmten Ereignisses erfolgt ein Generieren 1412 von auf den ersten abgeleiteten Daten 216 basierenden Ereignisdaten 125. Da das Ereignis des maximale Leistungswertes 426W ist und diesem maximale Leistungswert das Zeitsignal 482 von 3,75ms zugeordnet ist bzw. auf diesem basiert, bestehen die Ereignisdaten 125 in diesem Fall aus den beiden Werten 426W und 3,75ms, die dann der zweiten Verknüpfungseinheit 435 zugeführt werden.

In der zweiten Verknüpfungseinheit 435 erfolgt dann ein Versehen 1435 der Ereignisdaten 125 mit einem Zeitstempel. Dieser Zeitstempel basiert, wie beschrieben, auf einer Verknüpfung der von der ersten Uhr bereitgestellten synchronisierten Uhrzeit 480 und dem den ersten abgeleiteten Daten 216 des Ereignisses zugeordneten Zeitsignal. Gemäß dem Beispiel wird also die synchronisierte Uhrzeit 480 mit dem Wert 1. Januar 2018; 12:05:05,251491387 Uhr mit dem Wert des Zeitsignals 482 an dem das gesuchte Ereignis, also der maximale Leistungswert eingetreten ist, also gemäß dem Beispiel der Wert 3,75ms addiert. Somit ergibt sich ein Zeitstempel mit dem Wert: 1. Januar 2018;

12:05:05,255241387 Uhr.

Mittels des Versehens 1435 der Ereignisdaten 125 mit dem Zeitstempel erfolgt ein Generieren 2435 von Nutzdaten 427, die dann in einem abschließenden, hier nicht dargestellten Verfahrensschritt über das Kommunikationsnetzwerk 430 gesendet werden.

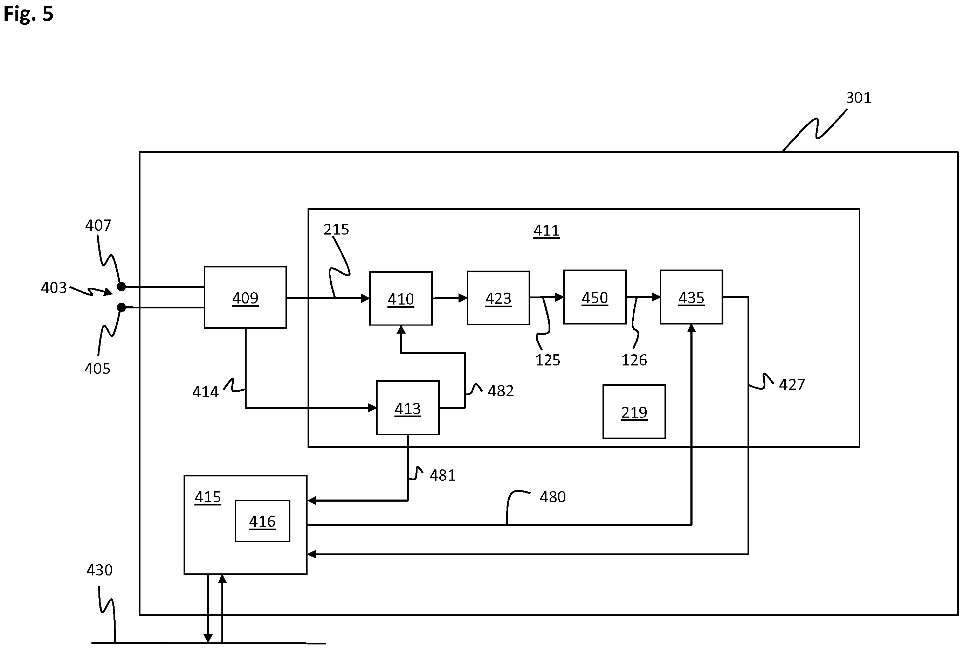

Fig. 5 zeigt eine dritte Busklemme 301 eines Automatisierungssystems (nicht gezeigt) zum Überwachen eines Versorgungsstromnetzes 403.

Die dritte Busklemme 301 entspricht im Aufbau und der Funktionsweise in wesentlichen Teilen dem Aufbau und der Funktionsweise der ersten Busklemme 101 gemäß Figur 1, so dass um Wiederholungen zu vermeiden im Folgenden nur auf die Unterschiede eingegangen wird.

Neben den zu Figur 1 beschriebenen Einheiten der ersten Busklemme 101 weist die dritte Busklemme 301, insbesondere die Prozessoreinrichtung 411 eine zweite Auswerteeinheit 450 auf, welche funktional zwischen der Sucheinheit 423 und der zweiten Verknüpfungseinheit 435 angeordnet ist. Die zweite Auswerteeinheit 450 ist ausgebildet, die seitens der Sucheinheit 423 generierten Ereignisdaten 125 zu empfangen. Die Ereignisdaten 125 werden dann seitens der zweiten Auswerteeinheit 450 beispielsweise mit weiteren Ereignisdaten 125 verknüpft und/oder die Ereignisdaten 125 werden mittels einer mathematischen Funktion verarbeitet. Somit werden aus den Ereignisdaten 125 zweite abgeleitete Daten 126 generiert, die dann anstelle der Ereignisdaten 125 an die zweite Verknüpfungseinheit 435 übermittelt und analog zu der weiter oben beschriebenen Vorgehensweise in Bezug auf die Ereignisdaten 125 weiterverarbeitet werden.

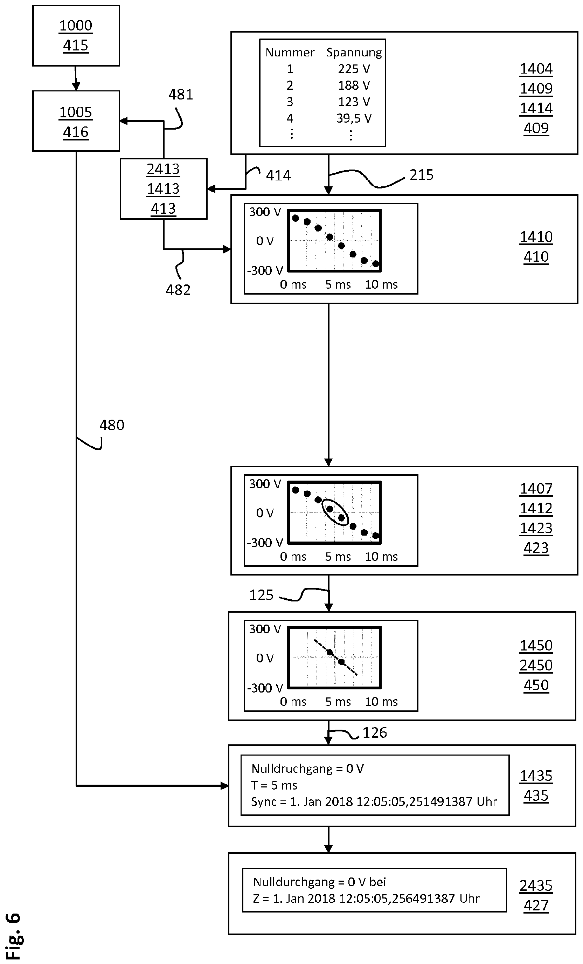

Fig. 6 zeigt ein schematisiertes, beispielhaftes Ablaufdiagramm eines Verfahrens zum Überwachen eines Versorgungsstromnetzes unter Verwendung der dritten Busklemme 301.

Da die dritte Busklemme 301 im Aufbau und der Funktionsweise in wesentlichen Teilen dem Aufbau und der Funktionsweise der ersten Busklemme 101 gemäß Figur 1 entspricht, wird, um Wiederholungen zu vermeiden, im Folgenden nur auf die Unterschiede eingegangen.

In dem in Figur 6 dargestellten Beispiel erfolgt mittels des Messumsetzers 409 ein Messen 1404 einer elektrischen Größe des Versorgungsstromnetzes 403, in dem Fall ein Messen 1404 einer elektrischen Spannung einer Phase 407 des Versorgungsstromnetzes 403. Die einzelnen Spannungswerte werden seitens des Messumformers 409 bereitgestellt 1409. Beispielweise wird als erstes Messdatum 215 ein Spannungswert von 225V, als zweites Messdatum 215 ein Spannungswert von 188V, als drittes Messdatum 215 ein Spannungswert von 123V, als viertes Messdatum 215 ein Spannungswert von 39,5V und so weiter bereitgestellt 1409. Das weitere Verfahren erfolgt analog zu der Beschreibung zu Figur 2.

Ebenfalls analog zu dem Beispiel zu Figur 2 erfolgt in der ersten Verknüpfungseinheit 410 dann ein Zuordnen 1410 der digitalen Messdaten 215 zu den Zeitsignalen 482. Somit wird beispielsweise ein Spannungs-/Zeitdiagramm erstellt, welches im dargestellten Beispiel pro einskommazweifünf Millisekunden einen Spannungswert enthält.

In einem nächsten Schritt erfolgt eine Untersuchung 1423 der digitalen Messdaten 215 auf ein vorbestimmtes Ereignis hin. In dem dargestellten Beispiel wird beispielsweise ein Vorzeichenwechsel der Spannungswerte als vorbestimmtes Ereignis für einen Nulldurchgang gesucht. Also untersucht 1423 die Sucheinheit 423 die bereitgestellten digitalen Messdaten 215 auf einen Vorzeichenwechsel hin. Das Auffinden des letzten positiven Spannungswertes und des ersten negativen Spannungswertes also das Eintreten 1407 des vorbestimmten Ereignisses im Rahmen der Untersuchung 1423 ist in der Figur 6 durch einen Kreis um die entsprechenden Werte markiert und versinnbildlicht. Aufgrund des Eintretens 1423 des vorbestimmten Ereignisses erfolgt ein Generieren 1412 von auf den Messdaten 215 basierenden Ereignisdaten 125. Die Ereignisdaten 125 bestehen in diesem Fall aus den zwei Spannungswerten mit jeweils zugeordnetem Zeitsignal, die dann der zweiten Auswerteeinheit 450 zugeführt werden.

Die beiden Ereignisdaten für die Spannung werden dann seitens der zweiten Auswerteeinheit 450 empfangen und diese werden dann miteinander verknüpft 1450. Im Rahmen der Verknüpfung 1450 erfolgt eine lineare Approximation der beiden Spannungen in Verbindung mit den zugehörigen Zeitsignalen, um somit den genauen Zeitpunkt bzw. das zugehörige Zeitsignal des Nulldurchgangs zu erzeugen. Mittels der Erzeugung werden zweite abgeleitete Daten 126 generiert 2450, die dann der zweiten Verknüpfungseinheit 435 zugeführt werden.

Die zweiten abgeleiteten Daten 126 werden dann in der zweiten Verknüpfungseinheit 435 analog zu den im Zusammenhang mit Figur 1 beschriebenen Ereignisdaten 125 behandelt.

In der zweiten Verknüpfungseinheit 435 erfolgt dann beispielsweise ein Versehen 1435 der zweiten abgeleiteten Daten 126 mit einem Zeitstempel. Dieser Zeitstempel basiert, wie beschrieben, auf einer Verknüpfung der von der ersten Uhr bereitgestellten synchronisierten Uhrzeit 480 und dem den zweiten abgeleiteten Daten 126 zugeordneten Zeitsignal. Gemäß dem Beispiel wird also die synchronisierte Uhrzeit 480 mit dem Wert 1. Januar 2018; 12:05:05,251491387 Uhr mit dem abgeleiteten Wert des Zeitsignals an dem das gesuchte Ereignis, also der Nulldurchgang eingetreten ist, also gemäß dem Beispiel der Wert 5ms addiert. Somit ergibt sich ein Zeitstempel mit dem Wert: 1. Januar 2018; 12:05:05,256491387 Uhr.

Mittels des Versehens 1435 der zweiten abgeleiteten Daten 126 mit dem Zeitstempel erfolgt ein Generieren 2435 von Nutzdaten 427, die dann in einem abschließenden, hier nicht dargestellten Verfahrensschritt über das Kommunikationsnetzwerk 430 gesendet werden.

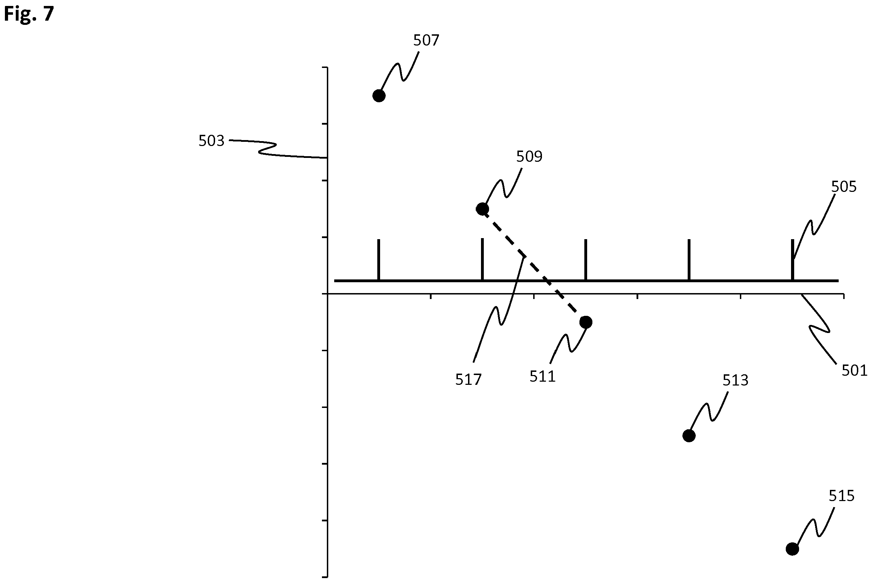

Fig. 7 zeigt nochmals detaillierter eine Nulldurchgangsbestimmung basierend auf einer linearen Approximation. Fig. 7 zeigt einen Graphen umfassend eine Abszisse 501 und eine Ordinate 503.

Die Abszisse 501 gibt beispielsweise die Zeit in Sekunden an. Die Ordinate 503 gibt beispielsweise eine elektrische Spannung gemessen zwischen dem Nullleiter 405 und der Phase 407 des in Fig. 5 gezeigten Versorgungsstromnetzes 403 an.

Die Kurve mit dem Bezugszeichen 505 beschreibt eine Abtastrate der analogen Messdaten.

Die Messpunkte 507, 509, 511, 513, 515 entsprechen somit dieser Abtastrate entsprechenden digitalen Messdaten.

Zur Approximation des Nulldurchgangs wird durch die beiden Messpunkte 509,511, die dem Nulldurchgang am nächsten liegen, eine Gerade 517 gelegt, die sich vorliegend mit folgender Gleichung beschreiben lässt:

$$y = m \cdot x + b$$

Hierbei ist y die Spannung, m die Steigung der Geraden, x die Zeit und b der y-Achsenabschnitt. Durch Ermitteln der Nullstelle dieser Funktion, lässt sich der Nulldurchgang der elektrischen Spannung approximieren.

Mithilfe der aktuellen Frequenz und der Frequenzänderung des Versorgungsstromnetzes 403 lässt sich somit in vorteilhafter Weise der nächste (also in der Zukunft liegende) Nulldurchgang prognostizieren.

Die Nulldurchgangsbestimmung ist hierbei auf beispielsweise eine Mikrosekunde genau.

Ein Abstand zwischen zwei Messpunkten beträgt zum Beispiel 113μs bei einer Abtastrate von neuntausendsiebenhundert Messdaten pro Sekunde.

Der Arbeitsbereich der Frequenz des zu prüfenden beziehungsweise zu überwachenden Versorgungsstromnetzes beträgt beispielsweise 45Hz bis 65Hz. Bei einer Frequenz von 50Hz beträgt die Periode 20ms, somit erfolgt alle 10ms ein Nulldurchgang. Die Laufzeit beziehungsweise Verzögerung eines Tiefpass-Frequenz-Filters kann ein Auswerten des aktuellen Nulldurchgangs verzögern, weshalb beispielsweise der Zeitpunkt des vorletzten Nulldurchgangs durch die Busklemme ausgegeben wird. Das Auftreten der Nulldurchgänge startet beispielsweise jeweils einen Zeitgeber. Aus einer Messreihe heraus lässt sich die Momentanfrequenz und durch die Ableitung eine Frequenzänderung messen.

Eine Busklemme misst gemäß einer Ausführungsform einen oder mehrere der folgenden Werte:

- elektrische Spannung (bei einem dreiphasigen Wechselstromnetz beispielsweise drei Spannungen (eine Spannung je Phase) und

- elektrischer Strom (bei einem dreiphasigen Wechselstromnetz beispielsweise drei elektrische Ströme (ein elektrischer Strom je Phase)

Eine Abtastrate beträgt in einer Ausführungsform neuntausendsiebenhundert Abtastwerte pro Sekunde. Eine Abtastrate liegt in einer Ausführungsform zwischen achttausend Abtastwerte pro Sekunde und zwölftausend Abtastwerte pro Sekunde.

Diese gemessenen Werten werden ausgewertet, wobei im Rahmen der Auswertung aus diesen gemessenen Werten zum Beispiel ein oder mehrere der folgenden Werte ermittelt bzw. berechnet werden:

- jeweiliger Effektivwert der gemessenen Spannung bzw. des gemessenen Stroms, zum Beispiel der drei Spannungen und drei Ströme bei einem dreiphasigen Wechselstromnetz,
- jeweiliger Effektivwert einer, beispielsweise der drei, Außenleiterspannung(en), eines Wechselstromnetzes,
- jeweilige Überspannung pro Phase, also zum Beispiel drei Überspannungen, eines Wechselstromnetzes, (eine Überspannung ist beispielsweise ein Ereignis),
- jeweiliger Überstrom pro Phase, also zum Beispiel drei Überströme, eines Wechselstromnetzes, (ein Überstrom ist beispielsweise ein Ereignis),
- jeweils je Phase eine Wirkleistung, eine Scheinleistung, eine Blindleistung, ein Leistungsfaktor bzw. Powerfaktor, eine Frequenz,
- ein letzter Nulldurchgang der gemessenen Spannung
- eine jeweilige harmonische Oberschwingung der Strangspannungen und Ströme je Phase,
- eine jeweilige Wirkenergie je Phase und/oder eine gesamte Wirkenergie,
- eine jeweilige Scheinenergie je Phase und/oder eine gesamte Scheinenergie
- eine jeweilige Blindenergie je Phase und/oder eine gesamte Blindenergie.

Zum Beispiel berechnet bzw. ermittelt die Prozessoreinrichtung im Rahmen der Auswertung gemäß einer Ausführungsform ein oder mehrere der folgenden statistischen Daten:

- eine jeweilige Wirkleistung, eine jeweilige Scheinleistung und/oder eine jeweilige Blindleistung je Phase,
- einen jeweiligen Maximalwert der drei Stromeingänge,
- einen jeweiligen Minimal- und/oder Maximalwert des Effektivwerts der jeweiligen Ströme je Phase,
- einen jeweiligen Minimal- und/ Maximalwert des Effektivwerts der jeweiligen Spannungen je Phase.

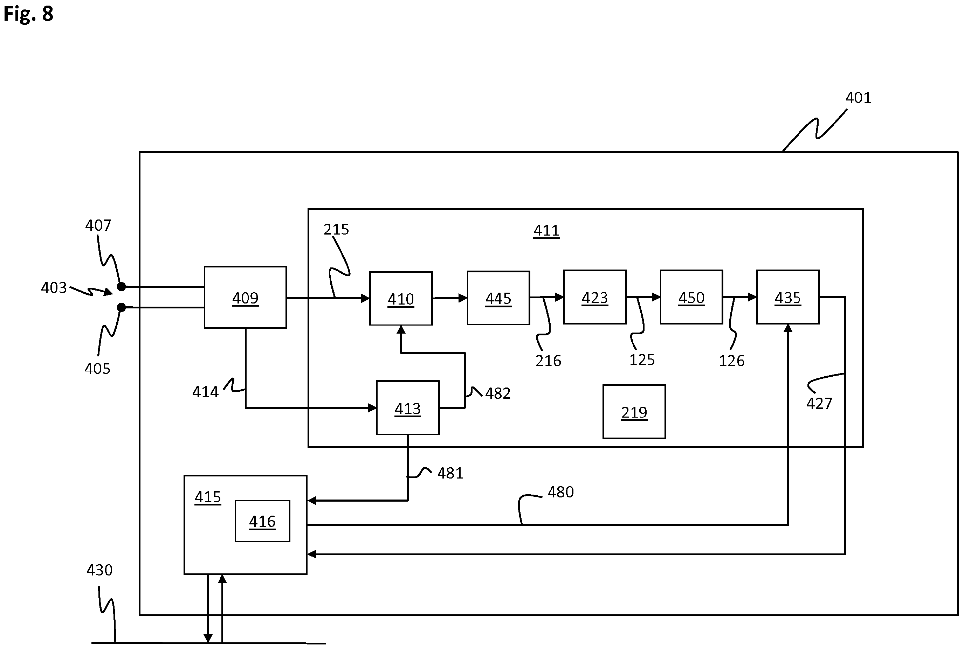

Fig. 8 zeigt eine vierte Busklemme 401 eines Automatisierungssystems (nicht gezeigt) zum Überwachen eines Versorgungsstromnetzes 403.

Die vierte Busklemme 401 entspricht im Aufbau und der Funktionsweise in wesentlichen Teilen einer Kombination aus dem Aufbau und der Funktionsweise der zweiten Busklemme 101 gemäß Figur 3 und der dritten Busklemme gemäß Figur 5, so dass um Wiederholungen zu vermeiden im Folgenden nur auf die Unterschiede eingegangen wird.

Die vierte Busklemme 401, insbesondere die Prozessoreinrichtung 411 weist sowohl eine erste Auswerteeinheit 445 auf, welche funktional zwischen der ersten Verknüpfungseinheit 410 und der Sucheinheit 423 angeordnet ist, als auch eine zweite Auswerteeinheit 450 auf, welche funktional zwischen der Sucheinheit 423 und der zweiten Verknüpfungseinheit 435 angeordnet ist. Die erste Auswerteeinheit 445 ist ausgebildet, die mit dem Zeitsignal 482 zugeordneten digitalen Messdaten 215 von der erste Verknüpfungseinheit 410 zu empfangen. Die digitalen Messdaten 215 werden dann seitens der ersten Auswerteeinheit 445 beispielsweise mit weiterer digitalem Messdaten 215 verknüpft und/oder die digitalen Messdaten 215 werden mittels einer mathematischen Funktion verarbeitet. Somit werden aus den digitalen Messdaten 215 erste abgeleitete Daten 216 generiert, die dann anstelle der digitalen Daten 215 an die Sucheinheit 423 übermittelt und analog zu der weiter oben beschriebenen Vorgehensweise in Bezug auf die digitalen Daten 215 weiterverarbeitet werden. Die zweite Auswerteeinheit 450 ist ausgebildet, die seitens der Sucheinheit 423 generierten Ereignisdaten 125 zu empfangen. Die Ereignisdaten 125 werden dann seitens der zweiten Auswerteeinheit 450 beispielsweise mit weiterer Ereignisdaten 125 verknüpft und/oder die Ereignisdaten 125 werden mittels einer mathematischen Funktion verarbeitet. Somit werden aus den Ereignisdaten 125 zweite abgeleitete Daten 126 generiert, die dann anstelle der Ereignisdaten 125 an die zweite Verknüpfungseinheit 435 übermittelt und analog zu der weiter oben beschriebenen Vorgehensweise in Bezug auf die Ereignisdaten 125 weiterverarbeitet werden.

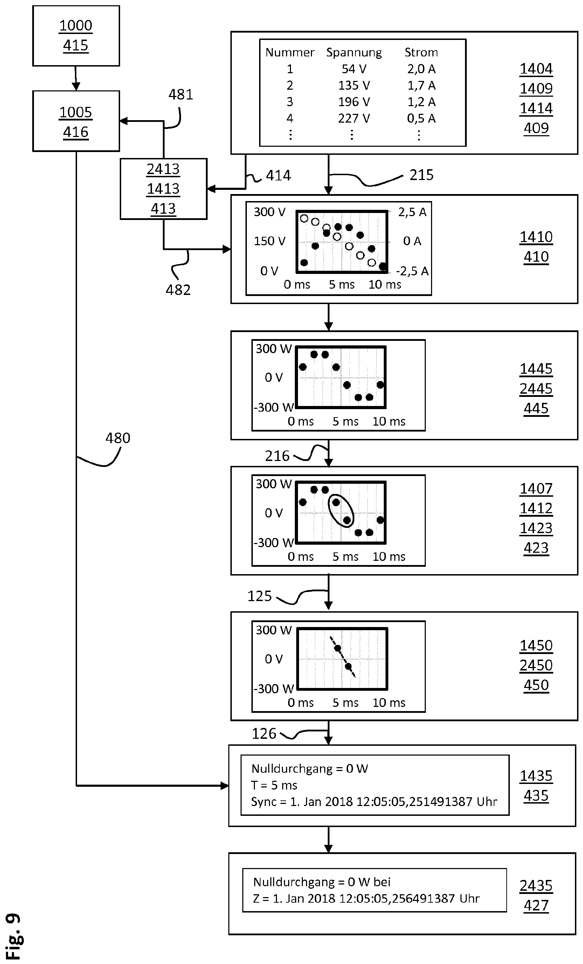

Fig. 9 zeigt ein schematisiertes, beispielhaftes Ablaufdiagramm eines Verfahrens zum Überwachen eines Versorgungsstromnetzes unter Verwendung der vierten Busklemme 401.

Da die vierte Busklemme 401 im Aufbau und der Funktionsweise in wesentlichen Teilen einer Kombination aus dem Aufbau und der Funktionsweise der zweiten Busklemme 101 gemäß Figur 3 und der dritten Busklemme gemäß Figur 5 entspricht, wird, um Wiederholungen zu vermeiden, im Folgenden nur auf die Unterschiede eingegangen.

In dem dargestellten Beispiel erfolgt mittels des Messumsetzers 409 ein Messen 1404 zweier elektrischen Größen des Versorgungsstromnetzes 403, in dem Fall ein Messen 1404 einer elektrischen Spannung und ein Messen einer Stromstärke einer Phase 407 des Versorgungsstromnetzes 403. Die einzelnen Spannungswerte und die einzelnen Stromstärkewerte werden seitens des Messumformers 409 bereitgestellt 1409. Beispielsweise werden als erste Messdaten 215 ein Spannungswert von 54V und eine Stromstärke von 2A, als zweite Messdaten 215 ein Spannungswert von 135V und eine Stromstärke von 1,7A, als dritte Messdaten 215 ein Spannungswert von 196V und eine Stromstärke von 1,2A, als vierte Messdaten 215 ein Spannungswert von 227V und eine Stromstärke von 0,5A und so weiter bereitgestellt 1409. Die bereitgestellten digitalen Messdaten 215 werden einzeln an die erste Verknüpfungseinheit 410 übermitteln. Das weitere Verfahren erfolgt analog zu der Beschreibung zu Figur 2.

Ebenfalls analog zu dem Beispiel zu Figur 2 erfolgt in der ersten Verknüpfungseinheit 410 ein Zuordnen 1410 der digitalen Messdaten 215 zu den Zeitsignalen 482. In dem in Figur 9 dargestellten Beispiel wird aufgrund der Mehrzahl an gemessenen Größen ein kombiniertes Spannungs-/Stromstärke-Zeitdiagramm erstellt, welches im dargestellten Beispiel pro einskommazweifünf Millisekunden einen Spannungswert und einen Stromstärkewert enthält. Die Höhe der Spannung ist an der linken Ordinate aufgetragen und die einzelnen Spannungswerte sind als gefüllte Punkte in Figur 9 dargestellt. Die Höhe der Stromstärke ist an der rechten Ordinate aufgetragen und die einzelnen Stromstärkenwerte sind als nicht gefüllte Punkte in Figur 9 dargestellt. Auf der Abszisse ist die Zeit in Millisekunden aufgetragen, wobei sich die Zeit auf die Zeitsignale der zweiten Uhr 413 bezieht.

Die einzelnen digitalen Messwerten 215 für die Spannung und die Stromstärke werden dann seitens der ersten Auswerteeinheit 445 empfangen und diese werden dann miteinander verknüpft 1445. Im Rahmen der Verknüpfung 1445 werden die einzelnen Spannungswerte und Stromstärkenwerte der jeweiligen Zeitsignale miteinander multipliziert, um somit ein Leistungs-/Zeitdiagramm zu erzeugen. Mittels der einzelnen Werte der Leistung zu den jeweiligen Zeitsignalen werden dann erste abgeleitete Daten 216 generiert 2445, die dann der Sucheinheit 423 zugeführt werden.

In einem nächsten Schritt erfolgt eine Untersuchung 1423 der ersten abgeleiteten Daten 216 auf ein vorbestimmtes Ereignis hin. In dem dargestellten Beispiel wird beispielsweise ein Vorzeichenwechsel der Leistungswerte als vorbestimmtes Ereignis für einen Nulldurchgang gesucht. Also untersucht 1423 die Sucheinheit 423 die ersten abgeleiteten Daten 216 auf einen Vorzeichenwechsel hin. Das Auffinden des letzten positiven Leistungswertes und des ersten negativen Leistungswertes also das Eintreten 1407 des vorbestimmten Ereignisses im Rahmen der Untersuchung 1423 ist in der Figur 9 durch einen Kreis um die entsprechenden Werte markiert und versinnbildlicht. Aufgrund des Eintretens 1423 des vorbestimmten Ereignisses erfolgt ein Generieren 1412 von auf ersten abgeleiteten Daten 216 basierenden Ereignisdaten 125. Die Ereignisdaten 125 bestehen in diesem Fall aus den zwei Leistungswerten mit jeweils zugeordnetem Zeitsignal, die dann der zweiten Auswerteeinheit 450 zugeführt werden.

Die beiden Ereignisdaten für die elektrische Leistung werden dann seitens der zweiten Auswerteeinheit 450 empfangen und diese werden dann miteinander verknüpft 1450. Im Rahmen der Verknüpfung 1450 erfolgt eine lineare Approximation der beiden Leistungen in Verbindung mit den zugehörigen Zeitsignalen, um somit den genauen Zeitpunkt bzw. das zugehörige Zeitsignal des Nulldurchgangs zu erzeugen. Mittels der Erzeugung werden zweite abgeleitete Daten 126 generiert 2450, die dann der zweiten Verknüpfungseinheit 435 zugeführt werden.

Die zweiten abgeleiteten Daten 126 werden dann in der zweiten Verknüpfungseinheit 435 analog zu den im Zusammenhang mit Figur 1 beschriebenen Ereignisdaten 125 behandelt.

In der zweiten Verknüpfungseinheit 435 erfolgt dann beispielsweise ein Versehen 1435 der zweiten abgeleiteten Daten 126 mit einem Zeitstempel. Dieser Zeitstempel basiert, wie beschrieben, auf einer Verknüpfung der von der ersten Uhr bereitgestellten synchronisierten Uhrzeit 480 und dem den zweiten abgeleiteten Daten 126 zugeordneten Zeitsignal. Gemäß dem Beispiel wird also die synchronisierte Uhrzeit 480 mit dem Wert 1. Januar 2018; 12:05:05,251491387 Uhr mit dem abgeleiteten Wert des Zeitsignals an dem das gesuchte Ereignis, also der Nulldurchgang eingetreten ist, also gemäß dem Beispiel der Wert 5ms addiert. Somit ergibt sich ein Zeitstempel mit dem Wert: 1. Januar 2018; 12:05:05,256491387 Uhr.

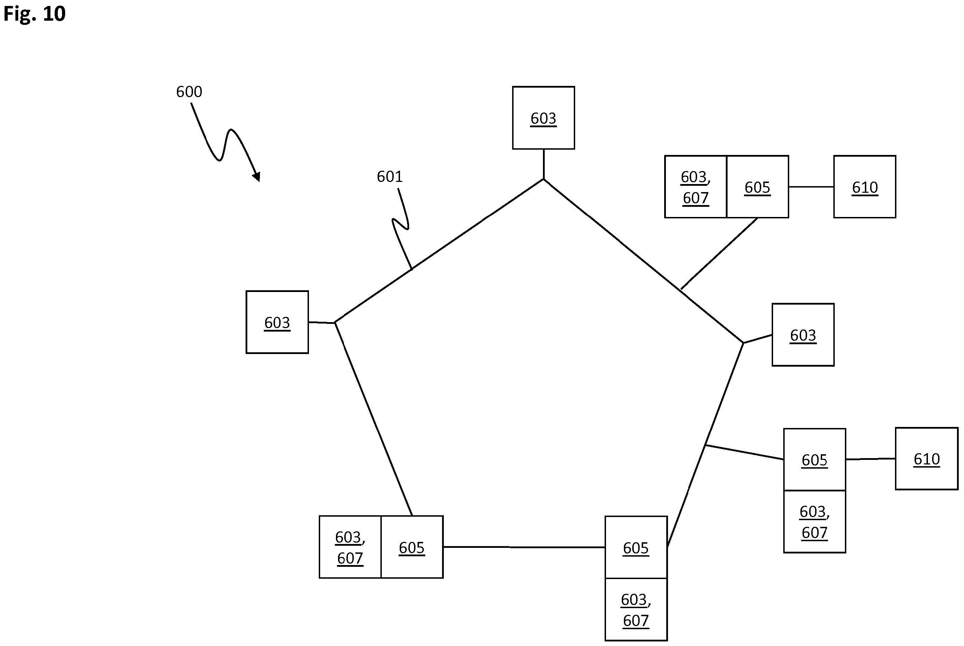

Fig. 10 zeigt ein erstes Versorgungsstromnetz 601 umfassend ein erstes Automatisierungssystem 600, wobei das erste Automatisierungssystem 600 ein nicht dargestelltes Kommunikationsnetzwerk umfasst und eine nicht dargestellte Steuerung aufweist.

Das erste Automatisierungssystem 600 umfasst mehrere Busklemmen 603 zum Überwachen des Versorgungsstromnetzes 601. Die Busklemmen 603 sind beispielsweise ausgebildet wie eine der zuvor beschriebenen ersten bis vierten Busklemmen 101, 201, 301, 401.

Die mehreren Busklemmen 603 bestimmen beispielsweise die Nulldurchgänge einer Spannung des Versorgungsstromnetzes 601. Einigen der Busklemmen 603 ist jeweils ein Schalter 605 zugeordnet, um an der entsprechenden Stelle im Versorgungsstromnetz 601 das Versorgungsstromnetz 601 zu unterbrechen. Die entsprechenden Busklemmen 603 sind noch zusätzlich mit dem Bezugszeichen 607 versehen. Die lokale Messung innerhalb der Busklemmen 607 kann dazu verwendet werden, die Schalter 605 in einem Nulldurchgang der Spannung zu schalten. Somit können Lasten bzw. Verbraucher 610, die den Schaltern 605 nachgeordnet sind, effizient vom Versorgungsstromnetz 601 getrennt werden und dabei die Verschleißerscheinungen an den Schaltern 605 geringer gehalten werden, gegenüber einem Schalten zu einer beliebigen Phase der Spannung.

Dadurch, dass der Zeitpunkt eines von einer ersten der mehreren Busklemmen 603 bestimmten Nulldurchgangs der Spannung auf einer für das gesamte Automatisierungssystem 600 vorgegebenen Referenzzeit beruht, kann, bei bekannten Abständen zwischen verschiedenen Punkten im Versorgungsstromnetz 601, von der Steuerung des Automatisierungssystems 600 prognostiziert werden, zu welchen Zeitpunkten ein Nulldurchgang an einem anderen Punkt im Versorgungsstromnetz 601 auftritt. Somit kann zum Beispiel auf die Busklemmen 607, die den Schaltern 605 zugeordnet sind, verzichtet werden, insofern für diese Messorte der Zeitpunkt des Nulldurchgangs effizient prognostiziert werden kann.

Somit ist also gemäß einer Ausführungsform vorgesehen, dass auf die Busklemmen 607 an den Schaltern 605 verzichtet wird, da den Schaltern der Zeitpunkt eines prognostizierten Nulldurchgangs über das Kommunikationsnetz mitgeteilt werden kann.

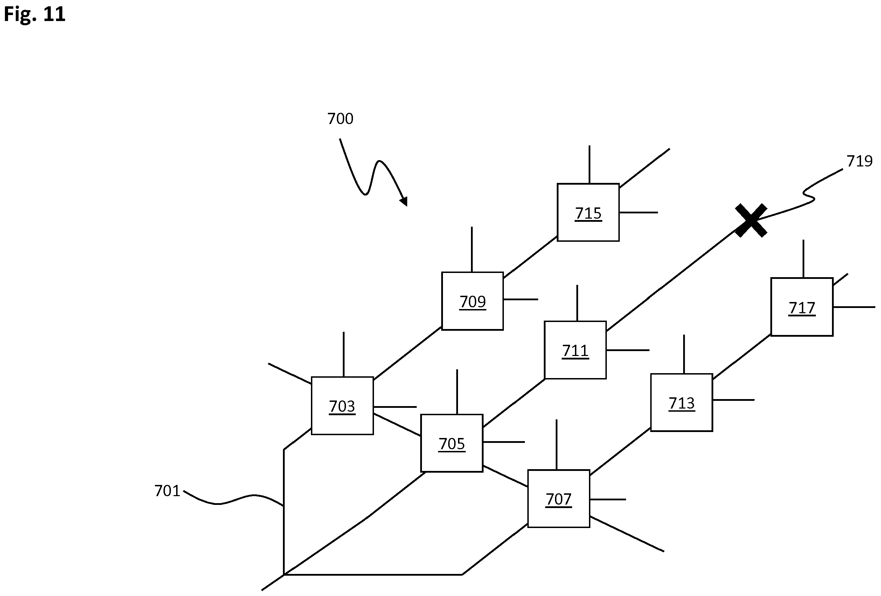

Fig. 11 zeigt ein zweites Versorgungsstromnetz 701, umfassend ein zweites Automatisierungssystem 700, wobei das zweite Automatisierungssystem 700 ein nicht dargestelltes Kommunikationsnetzwerk umfasst und eine nicht dargestellte Steuerung aufweist.

Das zweite Versorgungsstromnetz 701 umfasst mehrere Knoten 703, 705, 707, 709, 711, 713, 715, 717, an welchen jeweils eine Busklemme und eine Sicherung geschaltet ist. An diesen Knoten überwachen die Busklemmen das Versorgungsstromnetz 701 und die Sicherungen sichern das Versorgungstromnetz 701 gegen einen Überstrom ab.

Die Busklemmen sind beispielsweise ausgebildet wie eine der zuvor beschriebenen ersten bis vierten Busklemmen 101, 201, 301, 401.

Das Kreuz mit dem Bezugzeichen 719 gemäß Fig. 11 kennzeichnet einen Ort, an dem es zu einem Kurzschluss gekommen ist. Der daraus resultierende Spannungsabfall wird sich in dem Versorgungsstromnetz 701 maximal mit Lichtgeschwindigkeit ausbreiten. Bei einem Abstand der Knoten untereinander von mindestens 333 m, was einer minimalen Ausbreitungszeit des Spannungsabfalls zwischen zwei Knoten von 1 $\mu$s entspricht, kann durch die Verwendung der Busklemmen eine zeitliche und räumliche Ausbreitung des Spannungsabfalls detektiert werden. Dies deshalb, da die Busklemmen eine Zeitauflösung von Ereignissen wie beispielsweise einem Spannungsabfall von einer Mikrosekunde aufweisen.

Dies ermöglicht eine direkte Rekonstruktion des Ortes 719, an dem der Fehler im Versorgungsstromnetz 701 liegt, zumindest auf 333 m genau bzw. relativ zur Position der vorhandenen Busklemmen.

Dadurch kann beispielsweise zeitlich sehr direkt nach dem Auftreten des Fehlers der sinnvoll abzutrennende Teil des Versorgungsstromnetzes 701 bestimmt werden.

Ein weiterer Vorteil besteht insbesondere darin, dass das Suchfeld für die Fehlersuche stark eingeschränkt werden kann.

Bei bisher bekannten Versorgungsstromnetzen konnte es vorkommen, dass eine Sicherung an den Knoten 703, 705 oder 707 vor einer Sicherung an dem Knoten 711 die entsprechende Stromleitung unterbricht. Dadurch wurde aber ein unnötig großer Teil des Versorgungsstromnetzes 701 abgeschaltet.

Durch die Information, die durch die zeitliche Ausbreitung des Spannungsabfalls erhältlich ist, was durch die erfindungsgemäßen Busklemmen gemessen und über das Kommunikationsnetzwerk bereitgestellt wird, kann eine Sicherung am Knoten 711 nachträglich ausgelöst werden und die restlichen Teile des Versorgungsstromnetzes 701 wieder freigeschaltet werden. Bei bekannten Versorgungsstromnetzen hätte man hierfür erst aktiv nach dem Fehler suchen müssen und hätte erst nach Finden des Fehlers den Strang nach dem Knoten 703 wieder freigeben können.

Somit wird es also durch das erfindungsgemäße Konzept ermöglicht, Fehler im Versorgungsstromnetz effizient zu lokalisieren.

Zusammenfassend basiert die Erfindung insbesondere auf der Idee, für ein verteiltes Versorgungsstromnetz an bestimmten Orten gemessene Parameter des Versorgungsstromnetzes bzw. bestimmte Ereignisse (zum Beispiel Spannungsabfall, Nulldurchgang einer Spannung) mit einem Zeitstempel zu versehen, der basierend auf einer synchronisierten internen Uhr der Busklemme und basierend auf einer für das gesamte Automatisierungssystem gültigen Referenzzeit ermittelt wurde und mit den Messdaten zeitlich verknüpft ist. Das heißt also, dass die Busklemme zum Beispiel einen gemessenen Parameter bzw. ein bestimmtes Ereignis in einem Wechselstromnetz mit einer für das gesamte Automatisierungssystem synchronisierten Zeit verknüpft. Somit kann der Wert des Parameters bzw. der Zeitpunkt des Ereignisses zeitlich für das gesamte Automatisierungssystem eingeordnet werden.

**Patentansprüche**

1. Busklemme (101, 201, 301, 401) für ein Automatisierungssystem (600, 700) zum Überwachen eines Versorgungsstromnetzes (403), wobei die Busklemme (101, 201, 301, 401) umfasst:

    eine erste Uhr (416),
    eine Kommunikationsschnittstelle (415) zum Kommunizieren über ein Kommunikationsnetzwerk (430) des Automatisierungssystems (600, 700),
    wobei die Kommunikationsschnittstelle (415) ausgebildet ist,
    eine Referenzzeit über das Kommunikationsnetzwerk (430) zu empfangen,
    wobei die Kommunikationsschnittstelle (415) ausgebildet ist,
    die Uhrzeit der ersten Uhr (416) auf die Referenzzeit zu synchronisieren,
einen als Analog-Digital-Umsetzer ausgebildeten Messumsetzer (409) zum Messen einer oder mehrerer elektrischer Größen des Versorgungsstromnetzes (403, 601, 701), um basierend auf der einen oder den mehreren gemessenen elektrischen Größen entsprechende digitale Messdaten (215) bereitzustellen,
und eine Prozessoreinrichtung (411) aufweisend:

    eine zweite Uhr (413), die ausgebildet ist, basierend auf einem der zweiten Uhr (413) vom Messumsetzer (409) zugeführten Bereitstellungssignal (414) ein Zeitsignal (482) zu generieren, wobei die zweite Uhr (413) weiterhin ausgebildet ist,
    die erste Uhr (416) zu veranlassen, periodisch die synchronisierte Uhrzeit (480) bereitzustellen,
    eine erste Verknüpfungseinheit (410), die ausgebildet ist,
    den bereitgestellten digitalen Messdaten (215) das Zeitsignal (482) zuzuordnen,
    eine Sucheinheit (423), die ausgebildet ist, die bereitgestellten digitalen Messdaten (215) und/oder auf den bereitgestellten digitalen Messdaten (215) basierende erste abgeleitete Daten (216) auf das Eintreten eines oder mehrerer vorbestimmter Ereignisse hin zu untersuchen, um basierend auf der Feststellung des Eintreten eines oder mehrerer vorbestimmter Ereignisse entsprechende, auf den digitalen Messdaten (215) und/oder auf den ersten abgeleiteten Daten (216) des Ereignisses oder der Ereignisse basierende Ereignisdaten (125) zu generieren,
    eine zweite Verknüpfungseinheit (435), die ausgebildet ist,
    die Ereignisdaten (125) und/oder auf den Ereignisdaten (125) basierende zweite abgeleitete Daten (126) mit einem Zeitstempel zu versehen, um somit Nutzdaten (427) zu generieren, wobei der Zeitstempel basiert auf einer Verknüpfung der von der ersten Uhr (416) bereitgestellten synchronisierten Uhrzeit (480) und dem den digitalen Messdaten (215) des Ereignisses oder der Ereignisse zugeordneten Zeitsignal (482),
    wobei die Kommunikationsschnittstelle (415) ausgebildet ist,
    die generierten Nutzdaten (427) über das Kommunikationsnetzwerk (430) zu senden.

2. Busklemme (101, 201, 301, 401) nach Anspruch 1, wobei die Prozessoreinrichtung (411) eine erste Auswerteeinheit (445) aufweist, die von der ersten Verknüpfungseinheit (410) die mit dem Zeitsignal (482) zugeordneten digitalen Messdaten (215) empfängt, wobei die erste Auswerteeinheit (445) ausgebildet ist, die digitalen Messdaten (215) mit weiteren digitalen Messdaten (215) zu verknüpfen und/oder die digitalen Messdaten (215) mittels einer mathematischen Funktion zu verarbeiten, um somit erste abgeleitete Daten (216) zu generieren, die der Sucheinheit (423) zuführbar sind.

3. Busklemme (101, 201, 301, 401) nach Anspruch 1 oder 2, wobei die Prozessoreinrichtung (411) eine zweite Auswerteeinheit (450) aufweist, die von der Sucheinheit (423) die Ereignisdaten (125) empfängt, wobei die zweite Auswerteeinheit (450) ausgebildet ist, die Ereignisdaten (125) mit weiteren Ereignisdaten (125) und/oder mit weiteren digitalen Messdaten (215) zu verknüpfen und/oder die Ereignisdaten (125) mittels einer mathematischen Funktion zu verarbeiten, um somit zweite abgeleitete Daten (126) zu generieren, die der zweite Verknüpfungseinheit (435) zuführbar sind.

4. Busklemme (101, 201, 301, 401) nach einem der vorherigen Ansprüche, wobei das oder die mehreren vorbestimmten Ereignisse beispielsweise ausgewählt sind aus der folgenden Gruppe von Ereignissen:

    ein Spannungsabfall im Versorgungsstromnetz (403, 601, 701) unter einen vorbestimmten Spannungsschwellwert,
    ein Stromabfall im Versorgungsstromnetz (403, 601, 701) unter einen vorbestimmten Stromschwellwert,
    ein Stromanstieg im Versorgungsstromnetz (403, 601, 701) über einen vorbestimmten Stromschwellwert,
    ein zeitlicher Verlauf einer gemessenen elektrischen Größe entspricht einem vorbestimmten zeitlichen Soll-Verlauf oder weicht von diesem ab und/oder
    das Auftreten eines Nulldurchgangs einer Phase bei einem als Wechselstromnetzwerk ausgebildeten Versorgungsstromnetz (403, 601, 701).

5. Busklemme (101, 201, 301, 401) nach einem der vorherigen Ansprüche, umfassend einen Speicher (219) zum Speichern eines oder mehrerer Programme zum Untersuchen mittels der Sucheinheit (423), zum Generieren von ersten abgeleiteten Daten (216) mittels der ersten Auswerteeinheit (445) und/oder zum Generieren von zweiten abgeleiteten Daten (126) mittels der zweiten Auswerteeinheit (450), wobei die Prozessoreinrichtung (411) ausgebildet ist, das oder die Programme aus dem Speicher (219) auszulesen und auszuführen, wobei die Kommunikationsschnittstelle (415) ausgebildet ist, das oder die Programme und/oder Aktualisierungsdaten für das oder die Programme über das Kommunikationsnetzwerk (430) zu empfangen, wobei die Prozessoreinrichtung (411) ausgebildet ist, das oder die empfangenen Programme in dem Speicher (219) zu speichern und/oder das oder die Programme basierend auf den Aktualisierungsdaten zu aktualisieren.

6. Verfahren zum Überwachen eines Versorgungsstromnetzes (403) unter Verwendung der Busklemme (101, 201, 301, 401) nach einem der vorherigen Ansprüche, umfassend die folgenden Schritte:

    Empfangen (1000) einer Referenzzeit über das Kommunikationsnetzwerk (430),
    Synchronisieren (1005) der Uhrzeit der ersten Uhr (416) auf die Referenzzeit,
    Messen (1404) einer oder mehrerer elektrischer Größen des Versorgungsstromnetzes (403) mittels des als Analog-Digital-Umsetzer ausgebildeten Messumsetzers (409),
    Bereitstellen (1409) von auf der einen oder den mehreren gemessenen elektrischen Größen entsprechend basierenden digitalen Messdaten (215),
    Zuführen (1414) eines Bereitstellungssignals (414) seitens des Messumsetzers (409) an die zweite Uhr (413), sobald digitale Messdaten (215) bereitstehen,
    Generieren (1413) eines Zeitsignals seitens der zweiten Uhr (413), wenn das Bereitstellungssignal (414) zugeführt wird, periodische Veranlassung (2413) der ersten Uhr (416) die synchronisierte Uhrzeit (480) bereitzustellen seitens der zweiten Uhr (413),
    Zuordnung (1410) des Zeitsignals (482) an die bereitgestellten digitalen Messdaten (215),
    Untersuchung (1423) der bereitgestellten digitalen Messdaten (215) und/oder der auf den bereitgestellten digitalen Messdaten (215) basierenden ersten abgeleiteten Daten (216) auf das Eintreten (1407) eines oder mehrerer vorbestimmter Ereignisse hin,
    basierend auf der Feststellung des Eintreten (1407) eines oder mehrerer vorbestimmter Ereignisse, Generierung (1412) von entsprechenden, auf den digitalen Messdaten (215) und/oder auf den ersten abgeleiteten Daten (216) des Ereignisses oder der Ereignisse basierenden Ereignisdaten (125),
    Versehen (1435) der Ereignisdaten (125) und/oder der auf den Ereignisdatendaten (125) basierenden zweiten abgeleiteten Daten (126) mit einem Zeitstempel, wobei der Zeitstempel basiert auf einer Verknüpfung der von der ersten Uhr (416) bereitgestellten synchronisierten Uhrzeit und dem den digitalen Messdaten (215) des Ereignisses oder der Ereignisse zugeordneten Zeitsignal (482),

Generieren (2435) von Nutzdaten (427) aus den mit dem Zeitstempel versehenen Ereignisdaten (125) und/oder den mit dem Zeitstempel versehenen, auf den Ereignisdatendaten (125) basierenden zweiten abgeleiteten Daten (126),

Senden der generierten Nutzdaten (427) über das Kommunikationsnetzwerk (430).

7. Verfahren nach Anspruch 6, umfassend die weiteren Schritte:

Empfangen von mit dem Zeitsignal zugeordneten digitalen Messdaten (215) seitens einer ersten Auswerteeinheit (445),

Verknüpfen (1445) der digitalen Messdaten (215) mit weiteren digitalen Messdaten (215) und/oder

Verarbeiten der digitalen Messdaten (215) mittels einer mathematischen Funktion,

dadurch Generieren (2245) von ersten abgeleiteten Daten (216) und

Zuführen der ersten abgeleiteten Daten (216) an die Sucheinheit (423).

8. Verfahren nach Anspruch 6 oder 7, umfassend die weiteren Schritte:

Empfangen der Ereignisdaten (125) seitens einer zweiten Auswerteeinheit (450),

Verknüpfen (1450) der Ereignisdaten (125) mit weiteren Ereignisdaten (125) und/oder

Verarbeiten der Ereignisdaten (125) mittels einer mathematischen Funktion,

dadurch Generieren (2450) von zweiten abgeleiteten Daten (126) und

Zuführen der zweiten abgeleiteten Daten (126) an die zweite Verknüpfungseinheit (435).

**Claims**

1. Bus terminal (101, 201, 301, 401) for an automation system (600, 700) for monitoring a power supply grid (403), wherein the bus terminal (101, 201, 301, 401) comprises:

a first clock (416),

a communication interface (415) for communicating via a communication network (430) of the automation system (600, 700),

wherein the communication interface (415) is configured to receive a reference time via the communication network (430),

wherein the communication interface (415) is configured to synchronize the time of the first clock (416) to the reference time,

a measurement converter (409), configured as an analogue-to-digital converter, for measuring one or

more electrical variables of the power supply grid (403, 601, 701), in order to take the one or more measured electrical variables as a basis for providing corresponding digital measurement data (215),

and a processor device (411) comprising:

a second clock (413), which is configured to take a provision signal (414) supplied to the second clock (413) by the measurement converter (409) as a basis for generating a time signal (482), wherein the second clock (413) is furthermore configured to prompt the first clock (416) to periodically provide the synchronized time (480),

a first logic unit (410) configured to assign the time signal (482) to the provided digital measurement data (215),

a searching unit (423) configured to examine the provided digital measurement data (215) and/or first derived data (216) based on the provided digital measurement data (215) for the occurrence of one or more predetermined events, in order to take the detection of the occurrence of one or more predetermined events as a basis for generating corresponding event data (125) based on the digital measurement data (215) and/or on the first derived data (216) of the event or events,

a second logic unit (435) configured to provide the event data (125) and/or second derived data (126) based on the event data (125) with a timestamp, in order therefore to generate payload data (427), wherein the timestamp is based on a combination of the synchronized time (480) provided by the first clock (416) and the time signal (482) assigned to the digital measurement data (215) of the event or events, wherein the communication interface (415) is configured to send the generated payload data (427) via the communication network (430).

2. Bus terminal (101, 201, 301, 401) according to Claim 1, wherein the processor device (411) comprises a first evaluation unit (445) that receives the digital measurement data (215) to which the time signal (482) is assigned from the first logic unit (410), wherein the first evaluation unit (445) is configured to combine the digital measurement data (215) with further digital measurement data (215) and/or to process the digital measurement data (215) by means of a mathematical function, in order therefore to generate first derived data (216) that are suppliable to the searching unit (423).

3. Bus terminal (101, 201, 301, 401) according to Claim 1 or 2, wherein the processor device (411) comprises a second evaluation unit (450) that receives the event data (125) from the searching unit (423), wherein the second evaluation unit (450) is configured to combine the event data (125) with further event data (125) and/or with further digital measurement data (215) and/or to process the event data (125) by means of a mathematical function, in order therefore to generate second derived data (126) that are suppliable to the second logic unit (435).

4. Bus terminal (101, 201, 301, 401) according to one of the preceding claims, wherein the predetermined event or the multiple predetermined events are selected from the following group of events, for example:

a voltage fall in the power supply grid (403, 601, 701) below a predetermined voltage threshold value,
a current fall in the power supply grid (403, 601, 701) below a predetermined current threshold value,
a current rise in the power supply grid (403, 601, 701) above a predetermined current threshold value,
a time characteristic of a measured electrical variable corresponds to a predetermined setpoint time characteristic or diverges therefrom and/or
the occurrence of a zero crossing in a phase in a power supply grid (403, 601, 701) configured as an AC network.

5. Bus terminal (101, 201, 301, 401) according to one of the preceding claims, comprising a memory (219) for storing one or more programs for the examination by means of the searching unit (423), for the generation of first derived data (216) by means of the first evaluation unit (445) and/or for the generation of second derived data (126) by means of the second evaluation unit (450), wherein the processor device (411) is configured to read and execute the program/s from the memory (219), wherein the communication interface (415) is configured to receive the program/s and/or update data for the program/s via the communication network (430), wherein the processor device (411) is configured to store the received program/s in the memory (219) and/or to update the program/s based on the update data.

6. Method for monitoring a power supply grid (403) by using the bus terminal (101, 201, 301, 401) according to one of the preceding claims, comprising the following steps:

receiving (1000) a reference time via the communication network (430),
synchronizing (1005) the time of the first clock (416) to the reference time,
measuring (1404) one or more electrical variables of the power supply grid (403) by means of the measurement converter (409) configured as an analogue-to-digital converter,
providing (1409) digital measurement data (215) correspondingly based on the one or more measured electrical variables,
the measurement converter (409) supplying (1414) a provision signal (414) to the second clock (413) as soon as digital measurement data (215) are available,
the second clock (413) generating (1413) a time signal if the provision signal (414) is supplied,
the second clock (413) periodically prompting (2413) the first clock (416) to provide the synchronized time (480),
assigning (1410) the time signal (482) to the provided digital measurement data (215),
examining (1423) the provided digital measurement data (215) and/or the first derived data (216) based on the provided digital measurement data (215) for the occurrence (1407) of one or more predetermined events,
taking the detection of the occurrence (1407) of one or
more predetermined events as a basis for generating (1412) corresponding event data (125) based on the digital measurement data (215) and/or the first derived data (216) of the event or events,
providing (1435) the event data (125) and/or the second derived data (126) based on the event data (125) with a timestamp, wherein the timestamp is based on a combination of the synchronized time provided by the first clock (416) and the time signal (482) assigned to the digital measurement data (215) of the event or events,
generating (2435) payload data (427) from the event data (125) provided with the timestamp and/or from the second derived data (126) provided with the timestamp and based on the event data (125),
sending the generated payload data (427) via the communication network (430).

7. Method according to Claim 6, comprising the further steps of:

a first evaluation unit (445) receiving digital measurement data (215) to which the time signal is assigned,
combining (1445) the digital measurement data (215) with further digital measurement data (215) and/or

processing the digital measurement data (215) by means of a mathematical function, generating (2245) first derived data (216) as a result and supplying the first derived data (216) to the searching unit (423) .

8. Method according to Claim 6 or 7, comprising the further steps of:

a second evaluation unit (450) receiving the event data (125), combining (1450) the event data (125) with further event data (125) and/or processing the event data (125) by means of a mathematical function, generating (2450) second derived data (126) as a result and supplying the second derived data (126) to the second logic unit (435).

**Revendications**

1. Borne de bus (101, 201, 301, 401) pour un système d'automatisation (600, 700) destiné à surveiller un réseau électrique d'alimentation (403), la borne de bus (101, 201, 301, 401) comprenant :

une première horloge (416), une interface de communication (415) pour communiquer par un réseau de communication (430) du système d'automatisation (600, 700), l'interface de communication (415) étant réalisée pour recevoir un temps de référence sur le réseau de communication (430), l'interface de communication (415) étant réalisée pour synchroniser l'heure de la première horloge (416) sur le temps de référence, un convertisseur de mesure (409) réalisé sous la forme d'un convertisseur analogique/numérique pour mesurer une ou plusieurs grandeurs électriques du réseau électrique d'alimentation (403, 601, 701) afin de fournir des données de mesure numériques (215) correspondantes sur la base des une ou plusieurs grandeurs électriques mesurées, et un dispositif de processeur (411) présentant :

une deuxième horloge (413) qui est réalisée pour générer un signal de temps (482) sur la base d'un signal de fourniture (414) délivré par le convertisseur de mesure (409) à la deuxième horloge (413), la deuxième horloge (413) étant en outre réalisée pour faire que la première horloge (416) fournisse périodiquement l'heure synchronisée (480),

une première unité d'association (410) qui est réalisée pour attribuer le signal de temps (482) aux données de mesure numériques (215) fournies,

une unité de recherche (423) qui est réalisée pour examiner les données de mesure numériques (215) fournies et/ou des premières données dérivées (216) basées sur les données de mesure numériques (215) fournies quant à l'occurrence d'un ou de plusieurs événements prédéterminés afin de générer, sur la base de la détermination de l'occurrence d'un ou de plusieurs événements prédéterminés, des données d'événement (125) correspondantes, basées sur les données de mesure numériques (215) et/ou sur les premières données dérivées (216) de l'événement ou des événements, une deuxième unité d'association (435) qui est réalisée pour horodater les données d'événement (125) et/ou des deuxièmes données dérivées (126) basées sur les données d'événement (125) afin de générer ainsi des données utiles (427), l'horodatage étant basé sur une association entre l'heure synchronisée (480) fournie par la première horloge (416) et le signal de temps (482) associé aux données de mesure numériques (215) de l'événement ou des événements, dans laquelle l'interface de communication (415) est réalisée pour envoyer les données utiles générées (427) sur le réseau de communication (430).

2. Borne de bus (101, 201, 301, 401) selon la revendication 1, dans laquelle le dispositif de processeur (411) présente une première unité d'évaluation (445) qui reçoit les données de mesure numériques (215) attribuées au signal de temps (482) de la première unité d'association (410), la première unité d'évaluation (445) étant réalisée pour associer les données de mesure numériques (215) à des données de mesure numériques (215) supplémentaires et/ou pour traiter les données de mesure numériques (215) au moyen d'une fonction mathématique afin de générer ainsi des premières données dérivées (216) qui peuvent être délivrées à l'unité de recherche (423).

3. Borne de bus (101, 201, 301, 401) selon la revendication 1 ou 2, dans laquelle le dispositif de processeur (411) présente une deuxième unité d'évaluation (450) qui reçoit les données d'événement (125) de l'unité de recherche (423), la deuxième unité d'évaluation (450) étant réalisée pour associer les données d'événement (125) à des données d'événement supplémentaires (125) et/ou à des données de mesure numériques (215) supplémentaires et/ou pour traiter les données d'événement (125) au moyen d'une fonction mathématique afin de générer ainsi des deuxièmes données dérivées (126) qui peuvent être délivrées à la deuxième unité d'association (435).

4. Borne de bus (101, 201, 301, 401) selon l'une quelconque des revendications précédentes, dans laquelle l'événement ou les plusieurs événements prédéterminés sont par exemple sélectionnés dans le groupe d'événements suivant :

une chute de tension dans le réseau électrique d'alimentation (403, 601, 701) au-dessous d'une valeur seuil de tension prédéterminée,
une chute de tension dans le réseau électrique d'alimentation (403, 601, 701) au-dessous d'une valeur seuil de courant prédéterminée,
une montée de courant dans le réseau électrique d'alimentation (403, 601, 701) au-dessus d'une valeur seuil de courant prédéterminée,
une courbe temporelle d'une grandeur électrique mesurée correspond à une courbe théorique temporelle prédéterminée ou dévie de celle-ci, et/ou
l'occurrence d'un passage par zéro d'une phase dans le cas d'un réseau électrique d'alimentation (403, 601, 701) réalisé sous la forme d'un réseau de courant alternatif.

5. Borne de bus (101, 201, 301, 401) selon l'une quelconque des revendications précédentes, comprenant une mémoire (219) pour stocker un ou plusieurs programmes pour un examen au moyen de l'unité de recherche (423), pour générer des premières données dérivées (216) au moyen de la première unité d'évaluation (445) et/ou pour générer des deuxièmes données dérivées (126) au moyen de la deuxième unité d'évaluation (450), le dispositif de processeur (411) étant réalisé pour lire le(s) programme(s) dans la mémoire (219) et pour les exécuter, dans laquelle l'interface de communication (415) est réalisée pour recevoir le(s) programme(s) et/ou des données de mise à jour pour le (s) programme (s) sur le réseau de communication (430), le dispositif de processeur (411) étant réalisé pour stocker le(s) programme(s) reçu(s) dans la mémoire (219) et/ou pour mettre à jour le (s) programme(s) sur la base des données de mise à jour.

6. Procédé de surveillance d'un réseau électrique d'alimentation (403) en utilisant la borne de bus (101, 201, 301, 401) selon l'une quelconque des revendications précédentes, comprenant les étapes suivantes consistant à :

recevoir (1000) un temps de référence sur le réseau de communication (430),

synchroniser (1005) l'heure de la première horloge (416) sur le temps de référence,
mesurer (1404) une ou plusieurs grandeurs électriques du réseau électrique d'alimentation (403) au moyen du convertisseur de mesure (409) réalisé sous la forme d'un convertisseur analogique/numérique,
fournir (1409) des données de mesure numériques (215) basées de façon correspondante sur ladite une ou les plusieurs grandeurs électriques mesurées,
délivrer (1414) un signal de fourniture (414) du côté du convertisseur de mesure (409) à la deuxième horloge (413) dès que des données de mesure numériques (215) sont disponibles,
générer (1413) un signal de temps du côté de la deuxième horloge (413) si le signal de fourniture (414) est délivré,
faire périodiquement (2413) que la première horloge (416) fournisse l'heure synchronisée (480) du côté de la deuxième horloge (413),
attribuer (1410) le signal de temps (482) aux données de mesure numériques (215) fournies,
examiner (1423) les données de mesure numériques (215) fournies et/ou les premières données dérivées (216) basées sur les données de mesure numériques (215) fournies quant à l'occurrence (1407) d'un ou de plusieurs événements prédéterminés,
sur la base de la détermination de l'occurrence (1407) d'un ou de plusieurs événements prédéterminés, générer (1412) des données d'événement (125) correspondantes, basées sur les données de mesure numériques (215) et/ou les premières données dérivées (216) de l'événement ou des événements,
horodater (1435) les données d'événement (125) et/ou les deuxièmes données dérivées (126) basées sur les données d'événement (125), l'horodatage étant basé sur une association entre l'heure synchronisée fournie par la première horloge (416) et le signal de temps (482) associé aux données de mesure numériques (215) de l'événement ou des événements,
générer (2435) des données utiles (427) à partir des données d'événement (125) horodatées et/ou à partir des deuxièmes données dérivées (126) basées sur les données d'événement (125),
envoyer les données utiles (427) générées sur le réseau de communication (430).

7. Procédé selon la revendication 6, comprenant les étapes supplémentaires consistant à :

recevoir des données de mesure numériques associées au signal de temps (215) du côté d'une première unité d'évaluation (445),

associer (1445) les données de mesure numériques (215) à des données de mesure numériques (215) supplémentaires, et/ou
traiter les données de mesure numériques (215) au moyen d'une fonction mathématique,
de ce fait, générer (2245) des premières données dérivées (216), et
délivrer les premières données dérivées (216) à l'unité de recherche (423).

8. Procédé selon la revendication 6 ou 7, comprenant les étapes supplémentaires consistant à :

recevoir les données d'événement (125) du côté d'une deuxième unité d'évaluation (450),
associer (1450) les données d'événement (125) à des données d'événement supplémentaires (125), et/ou
traiter les données d'événement (125) au moyen d'une fonction mathématique,
de ce fait générer (2450) des deuxièmes données dérivées (126), et
délivrer les deuxièmes données dérivées (126) à la deuxième unité d'association (435).

Fig. 1

Fig. 2

**Fig. 3**

EP 3 625 933 B1

```
1000
415
```

```
1005
416
```

481

| Nummer | Spannung | Strom |
|--------|----------|-------|
| 1 | 0 V | 1 A |
| 2 | 88 V | 1,6 A |
| 3 | 163 V | 1,9 A |
| 4 | 213 V | 2 A |
| ⋮ | ⋮ | ⋮ |

```
1404
1409
1414
409
```

```
2413
1413
413
```

414

215

```
1410
410
```

482

```
1445
2445
445
```

216

```
1407
1412
1423
423
```

480

125

Max = 426 W
T = 3,75 ms
Sync = 1. Jan 2018 12:05:05,251491387 Uhr

```
1435
435
```

Max = 426 W bei
Z = 1. Jan 2018 12:05:05,255241387 Uhr

```
2435
427
```

Fig. 4

**Fig. 5**

**Fig. 6**

```
1000
415
```

```
1005
416
```

481

```
Nummer   Spannung
   1        225 V        1404
   2        188 V        1409
   3        123 V        1414
   4        39,5 V       409
   ⋮          ⋮
```

414

215

```
2413
1413
413
```

482

```
300 V
  0 V              1410
-300 V             410
      0 ms   5 ms   10 ms
```

480

```
300 V              1407
  0 V              1412
-300 V             1423
      0 ms   5 ms   10 ms    423
```

125

```
300 V              1450
  0 V              2450
-300 V             450
      0 ms   5 ms   10 ms
```

126

```
Nulldruchgang = 0 V
T = 5 ms                                          1435
Sync = 1. Jan 2018 12:05:05,251491387 Uhr         435
```

```
Nulldurchgang = 0 V bei                           2435
Z = 1. Jan 2018 12:05:05,256491387 Uhr            427
```

**Fig. 7**

**Fig. 8**

EP 3 625 933 B1

**Fig. 9**

1000
415

1005
416

481

2413
1413
413

414

215

| Nummer | Spannung | Strom |
|--------|----------|-------|
| 1 | 54 V | 2,0 A |
| 2 | 135 V | 1,7 A |
| 3 | 196 V | 1,2 A |
| 4 | 227 V | 0,5 A |
| ⋮ | ⋮ | ⋮ |

1404
1409
1414
409

482

300 V / 150 V / 0 V — 2,5 A / 0 A / -2,5 A — 0 ms 5 ms 10 ms

1410
410

300 W / 0 V / -300 W — 0 ms 5 ms 10 ms

1445
2445
445

216

300 W / 0 V / -300 W — 0 ms 5 ms 10 ms

1407
1412
1423
423

125

300 W / 0 V / -300 W — 0 ms 5 ms 10 ms

1450
2450
450

126

480

Nulldurchgang = 0 W
T = 5 ms
Sync = 1. Jan 2018 12:05:05,251491387 Uhr

1435
435

Nulldurchgang = 0 W bei
Z = 1. Jan 2018 12:05:05,256491387 Uhr

2435
427

**Fig. 10**

EP 3 625 933 B1

**Fig. 11**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2017870 B1
- DE 2155470 B
- US 2017131343 A1
- WO 2015180766 A1
- DE 102014105211 A1

**In der Beschreibung aufgeführte Nicht-Patentliteratur**

- **SASCHA RENTZIG.** *Die Energiewende wird digital,* 01. Januar 2017, https://www.wago.com/medias/WAGOdirect-Energy-1-2017.pdf?
- Distributed Clock. *Spezifikation gemäß*
- Hardware Data Sheet Section 1 EtherCAT Slave Controller. Distributed Clocks. Beckhoff Automation GmbH & Ko. KG, 21. Februar 2017, I-52-I-74
- Hardware Data Sheet Section 1 EtherCAT Slave Controller. Distributed Clocks. Beckhoff Automation GmbH & Ko. KG, 21. Februar 2017, I-52-I-74